# EUROPEAN PATENT SPECIFICATION

(11) **EP 2 502 337 B1**
(45) Date of publication and mention of the grant of the patent: **15.01.2014**
(21) Application number: 10821427.1
(22) Date of filing: 17.11.2010
(51) Int. Cl.: H03F 1/02, H02M 3/156, H02M 3/335, H03F 3/187, H02M 1/00

(54) **POWER SUPPLYING SYSTEM**
STROMVERSORGUNGSSYSTEM
SYSTÈME D'ALIMENTATION ÉLECTRIQUE

(30) Priority: 19.11.2009 EP 09176451
(43) Date of publication of application: 26.09.2012
(73) Proprietor: TP Vision Holding B.V., 1097 JB Amsterdam (NL)
(72) Inventor: HOLLEVOET, Tony, André, Roger, NL-5656 AE Eindhoven (NL); ZEE, Kum, Yoong, NL-5656 AE Eindhoven (NL); FENG, Chengfang, NL-5656 AE Eindhoven (NL); SHUI, Zheng Quan, NL-5656 AE Eindhoven (NL)
(74) Representative: Nederlandsch Octrooibureau
(86) International application number: PCT/IB2010/055212
(87) International publication number: WO 2011/061688

(56) References cited:
- EP-A2- 1 592 115
- WO-A1-2008/146762
- JP-A- 2005 039 623
- JP-A- 2007 036 621
- US-A1- 2002 153 940
- US-A1- 2004 012 347
- US-A1- 2007 250 798
- US-B1- 6 262 545

## Description

### FIELD OF THE INVENTION

The invention relates to an apparatus comprising an audio and/or video processing circuit and a power converter for receiving a mains voltage and for providing power to the audio and/or video processing circuit

### BACKGROUND OF THE INVENTION

Electronic devices such as display apparatuses, audio amplifiers or radios comprise a power converter to provide a DC voltage to the apparatus. The power converter is often a switch mode power converter or a stabilized switch mode power converter which may comprise a series arrangement of a Power Factor Correction (PFC) circuit and a DC/DC converter.

The PFC and the DC/DC converter of the power converter are dimensioned to deliver a maximum amount of power. The passive components, like inductances and capacitors, as well as the active components, like semiconductor devices, are dimensioned for a long lasting safe and reliable operation of the main converter while delivering the maximum of power. The inductances are e.g. dimensioned such they do not become saturated at maximum power. The semiconductor devices are dimensioned such that they, for example, can conduct the expected maximum currents without being destructed. Further, the whole power supply including all its components is dimensioned such that generated heat may be initially absorbed and subsequently transferred into ambient of the power supply without overheating the power supply.

Though, several apparatuses that obtain power from the power supply device require, most of the time, less energy than the expected maximum power. The apparatuses require the maximum power only during short intervals. Thus, the components of the known main converter are overdimensioned for the average operating conditions. The overdimensioning results in high costs, too large power supply devices, and inefficiency as the result of, for example, high peak-current settings and high magnetizing currents.

An example of such an electronic device is a Liquid Crystal Display (LCD) television. In an LCD the light generated by a backlight is filtered by LCD cells which are the pixels that present the information of the video signal. The pixels of most of the frames of a video signal have an intensity that is lower than the maximum possible intensity. Current LCD television sets analyze the video signal and reduce the intensity of the backlight if almost all the pixels in one or several subsequent frames have a limited intensity that is lower than the maximum intensity value. Simultaneously, the absorption in the LCD cells is controlled such that more light of the backlight transfers through the LCD cells. Reducing the backlight intensity saves power. Only during periods of time when a video frame needs to be displayed with a high intensity of light, for example frames that present lightning, the backlight is controlled to deliver for a limited number of frames the maximum amount of light. In an LCD television the backlight has often a separate power converter. This power converter is configured to be able to deliver the maximum amount of power, which results in a power converter which is dimensioned too large with respect to the average amount of power that needs to be supplied to the backlight.

Further, the power converter provides the power at a constant supply voltage and/or a constant supply current to the apparatus that is required by the apparatus to operate at its maximum performance. However, the apparatus which consumes the power from the power converter does not operate efficiently when not operating at its maximum performance. For example, in an electronic device wherein an audio signal has to be amplified, an amplifier of the electronic device requires a specific supply voltage to amplify a signal to a specific maximum output level. The amplifier receives the specific supply voltage from a power converter. However, if the audio signal is not amplified to the maximum output level, the amplifier operates inefficiently.
EP1592115 A2 introduces a power supply architecture for driving a display backlight, in which efficiency is improved by applying a dual boost power factor correction circuit.

### SUMMARY OF THE INVENTION

It is an object of the invention to provide an apparatus according to the opening paragraph with a more efficient power converter system. The invention is defined by the independent claims. Advantageous embodiments are defined in the dependent claims.

A power converter system in accordance with the first aspect of the invention comprises a power converter, an analyzing circuit and a power converter controller. The power converter receives a mains voltage and provides power to a signal processing circuit that processes e.g. an audio signal and/or a video signal in normal operation. The power converter is configured for operating in either a first mode wherein the power converter is able to supply a first power level, or in a second mode wherein the power converter is able to supply a second power level. The second power level is larger than the first power level. For example, the audio signal is amplified to be made audible via speakers and the video signal is displayed on a display device of a display apparatus. The analyzing circuit receives the audio signal and/or the video signal and analyzes the audio signal and/or the video signal. The analyzing circuit generates a power signal that indicates a power consumption of the signal processing circuit in normal operation. The power converter controller receives the power signal and controls the power converter to operate in the first mode or in the second mode. The power converter is controlled to operate in the first mode when the power signal indicates that the power consumption of the signal processing circuit is below the first power level. The power converter is controlled to operate in the second mode when the power signal indicates that the power consumption of the signal processing circuit is above the first power level.

The analyzing circuit is able to indicate on basis of the information in the processed signal how much power is consumed by the signal processing circuit. The analyzing circuit has knowledge about the relation between characteristics of the signal and the power use of the signal processing circuit. For example, if the signal processing circuit is a plasma display device and if a video signal comprises a lot of high intensities, the signal processing circuit may have a relatively high power consumption. Or, in another example, if an audio signal comprises a lot of large amplitudes, the analyzing circuit knows that an amplifier that amplifies the signal consumes a lot of power.

Based on the power signal generated by the analyzing circuit, the power converter is controlled to operate in a mode in which it may provide power matching the maximum power use of the signal processing circuit in that mode. It is advantageous to adapt the power converter to be able to provide an amount of power that matches with the real use of the signal processing circuit. It prevents unnecessary inefficiency in the power converter and/or in the signal processing circuit. The power converter may be more efficient with regard to, for example, size and price, because it may be dimensioned such that is does not have to provide the second power level of power all the time. The power converter may be more efficient with regard to the prevention of, for example, high peak-current settings and high magnetizing currents at low loads.

Further or alternatively, the signal processing circuit may operate more efficient because it does not have to dissipate energy that is received from the power converter and which is not necessarily required to process the audio signal and/or process the video signal.

Depending on the specific type of power converter, the power converter may be controlled to operate in either the first mode or the second mode by means of different solutions. If the power converter is, for example, a switch mode power converter which comprises a transformer, the power converter may start to provide more energy to the transformer in response to the power signal, such that the amount of energy stored in the transformer relates to the amount of power which is consumed in the signal processing circuit. If the power converter only increases the energy to the transformer when this is required, unnecessary energy losses in the transformer are prevented. Or, for example, components that are not necessarily required to deliver the first power level to the signal processing circuit and are only useful when providing the second power level, may be switched off or become disconnected thereby preventing energy losses in these components in the form of, for example, thermal, magnetic or kinetic energy. In an embodiment, additional inductances or capacitors may be connected in parallel to inductances or capacitors of the power converter, respectively, in order to be able to convert more power in the second mode. Thus, controlling the power converter to operate in the first mode or in the second mode results in an efficient power converter in the first mode as well as in the second mode.

The power signal indicates the power consumption of the signal processing circuit when the signal processing circuit is in normal operation. It may be the calculated actual power use of the signal processing circuit or a calculated maximum power use. At least the power signal represents the minimal amount of power that the power converter has to provide in order to guarantee a correct operation of the signal processing circuit while, in normal operation, processing the audio and/or video signal on which the generated power signal is based. The provided power signal may be related to the power consumption in a specific interval of time, or related to respective power consumptions in successive intervals of time.

It is to be noted that the power signal relates to a normal operational mode of the signal processing circuit, and that the power provided in the first mode and in the second mode occur in the normal operational mode of the signal processing circuit. The invention does not relate to the power which is consumed by the signal processing circuit in a standby mode, although the power converter system of the present invention may very well have a standby mode on top of the above first and second modes. In the standby mode, the signal processing circuit consumes a little amount of energy and is not in normal operation, which means that the signal processing circuit is not processing the video signal and/or the audio signal to be displayed or to be made audible because of the absence of the video signal and/or audio signal, or because of a switched off signal processing circuit. In the normal operational mode the power consumption will be significant because an image will be displayed or sound will be made audible.

In an embodiment, the power signal indicates the power consumption of the signal processing circuit that is expected to be consumed during a time interval succeeding an instant at which the power signal is received. Thus, the power signal is a prediction of the power consumption of a succeeding time interval. Receiving the power signal before the start of the succeeding interval in which the power is consumed allows the power converter to proactively prepare for an expected change in power consumption which results in a more stable operation, for example, if the power converter is meant to provide a stable output voltage, the output voltage will be more stable. Known power converters have the disadvantage that they cannot immediately change the output power because, for example, power need to be stored in inductances before the stored power can be provided to the circuit that consumes the power. If the power consumption changes suddenly, the output voltage of the known power converters increase or decrease for short periods of time. The converters are not capable of providing the required power level during these short periods of time. The power converter of the embodiment is proactively prepared for the upcoming change of the power level and thus prevents the short periods of time during which the wrong amount of power is provided to the signal processing circuit. It is to be noted that the succeeding interval does not have to start immediately after the instant at which the power signal is received. In an embodiment there is a predefined delay between the instant at which the power signal is received and the instant at which the time interval starts.

In another embodiment, the power converter may operate in a plurality of modes and in each one of the plurality of modes the power converter is able to supply a specific one of a plurality of power levels. The power converter controller controls the power converter to operate in one of the plurality of modes which best matches the power consumption indicated by the power signal. A best match between the mode selected by the power converter controller and the power consumption of the signal processing circuit is the mode in which the specific power level of the selected mode is only a little higher than the power consumption of the signal processing circuit. In other words, the power converter controller selects the mode in which the value of the specific power level of the mode minus the power consumption is a positive value, but is as close as possible to zero. The value of the specific power level of the mode minus the power consumption is a measure for the inefficiency and by minimizing this value, the highest efficiency may be obtained. The more modes are available, the higher the probability is that a mode may be selected which results in a very small inefficiency. In an extreme case the number of modes is infinite by controlling the maximum power level which the power converter can provide on a continuous scale.

In another embodiment, the power converter provides an output voltage to the signal processing circuit in such a manner that in the first mode a first output voltage level is provided and in a second mode a second output voltage level is provided. The second output voltage level is higher than the first output voltage level. The analyzing circuit analyzes the audio signal and/or the video signal and generates the power signal that indicates an input voltage level that is required by the signal processing circuit for processing the audio signal and/or the video signal in normal operation. The power converter controller controls the power converter to operate in the first mode when the indicated input voltage level is below the first output voltage level and controls the power converter to operate in the second mode when the indicated input voltage level is above the first output voltage level. Providing a specific level of output power depends on the output voltage and/or the output current. Thus, providing an output voltage at a specific level is an effective solution for providing a specific amount of power. The analyzing circuit translates the power consumption of the signal processing circuit to a required input voltage level of the signal processing circuit. Subsequently, the power converter controller selects the mode of the power converter that matches the required input voltage level indicated by the power signal, and controls the power converter to operate in that mode.

The signal processing circuit may operate most efficiently when the signal processing circuit receives the right combination of a specific supply voltage and of an audio signal and/or a video signal with specific characteristics. The analyzing circuit generates a power signal that indicates which supply voltage to the signal processing circuit best matches the characteristics of the audio signal and/or the video signal. Subsequently, the power converter controller controls the power converter to provide a voltage level that is a relative good match between the required input voltage of the signal processing circuit and the characteristics of the audio signal and/or the video signal. The result is that the signal processing circuit operates relatively efficiently, especially when compared to the known power supplying systems that provide a constant voltage level.

In another embodiment, the power converter provides first and second output currents in the first and second modes, respectively. The analyzing circuit generates the power signal such that it indicates a required input current of the signal processing circuit. The power converter controller controls the power converter to operate in the first mode when the power signal indicates that the required input current is lower than the first output current, and controls the power converter to operate in the second mode when the power signal indicates that the required input current is higher than the first output current.

In a further embodiment, the power signal indicates a required input voltage and a required input current of the signal processing circuit. The power converter provides in the first mode a first output voltage level and a first output current level, and in the second mode a second output voltage level and a second output current level. The power converter controller selects the mode that best matches the requirements indicated by the power signal and controls the power converter to operate in the selected mode.

In an embodiment, the power converter comprises a primary side, a secondary side and a feedback circuit. The primary side receives a mains voltage and transfers power to the secondary side. The secondary side provides the output voltage. The feedback circuit provides feedback related to the output voltage level from the secondary side to the primary side to control at the primary side the power transfer to the secondary side. The use of the feedback circuit and the controlling of the power transfer stabilize the output voltage. The power converter controller changes the operation of the feedback circuit to control the mode of operation of the power converter. Known power converters have a structure with the feedback circuit. The feedback circuit provides, for example, in a mains separated power converter a signal to the primary side that indicates a difference value between the output voltage level and a reference voltage level. In another example the value of the output voltage level, or a tapped-in value of the output voltage level, is fed back to the primary side. The operation of the feedback circuit may be changed by changing the reference voltage, or tapping-in the value of the output voltage level with another tap-in factor than the regular tap-in factor. Instead of the value of the output voltage, the other tapped-in value of the output voltage level may be fed back to the primary side, or may be compared with the reference voltage. Influencing the operation of the feedback circuit is an effective solution to control the operation of the power converter in the first or in the second mode. Only minimal modifications to known power converters are required.

In another embodiment the power converter comprises a series arrangement of a power factor correction circuit and a main power converter. The main power converter provides power to the signal processing circuit. The power factor correction circuit is configured to supply in response to the power signal in the first mode a first voltage to the main power converter and supplying in response to the power signal in the second mode a second voltage which is higher than the first voltage. The main power converter is able to provide more power to the signal processing circuit if the power factor correction circuit delivers a higher output voltage. Thus, by controlling the output voltage of the power factor correction circuit, the power provided to the signal processing circuit by the main power converter is controlled. It is advantageous to provide a higher input voltage to the main power converter because it may operate, measured per watt transferred power, more efficient because of the higher input voltage. While providing more power to the signal processing circuit, many currents in the main power converter do not have to increase because of the higher input voltage. The dissipation of power relates to the square of the current and, thus, power losses are lower in the main power converter. The higher input voltage does not result in a larger dimensioning of the components of the main power circuit. Although, for example, the transformer needs another design to withstand the higher voltages, it does in general not result in a larger transformer. And, if larger dimensions are required for withstanding a higher voltage, this may be compensated by a smaller dimension because of less heat generation as the result of lower power losses.

In a further embodiment, the feedback circuit comprises a series arrangement of impedances tapping-in the output voltage. The power converter controller changes the operation of the feedback circuit by connecting another impedance in parallel to at least one of the impedances of the series arrangement of resistors. Known feedback circuits often have a series arrangement of impedances to tap-in the output voltage in order to feed back a signal related to the tapped-in output voltage. The signal is, for example, the voltage difference between a predefined reference voltage and the tapped-in output voltage. By influencing the tapping-in of the output voltage level, another voltage difference is obtained and another value is fed back to the primary side, resulting in another stabilized output voltage. The series arrangement of impedances form for example a voltage division circuit if the series arrangement of impedances is connected between the output voltage and the ground voltage and the feedback signal is obtained from a junction between two of the impedances of the series arrangement of impedances. Instead of connecting or disconnecting another impedance in parallel to one of the impedances, one of the impedances may be, at least partly, shortcircuited by the power converter controller. In an embodiment, the impedances are resistors. In another embodiment the impedance that is connected in parallel to one of the impedances of the series arrangement is a controllable impedance circuit having a variable impedance value.

In another embodiment the power converter comprises a series arrangement of a power factor correction circuit and a main power converter. The main power converter provides power to the signal processing circuit. The power factor correction circuit comprises an inductance, a switch, a feedback circuit and a switch controller. The switch generates a periodically varying current through the inductance. The feedback circuit provides a feedback signal related to an output voltage of the power factor correction circuit. The switch controller controls the switch in response to the feedback signal to stabilize the output voltage. The power converter controller is controlled for changing the operation of the feedback circuit to control the mode of operation of the power converter. Known power factor correction circuitries have often such a feedback circuit. Influencing the operation of the feedback circuit by the power converter controller circuit is an effective solution which does not require many modifications to the known power factor correction circuitries.

In a further embodiment, the feedback circuit comprises a series arrangement of impedances for tapping-in the output voltage of the power factor correction circuit. The power converter controller changes the operation of the feedback circuit by connecting another impedance in parallel to at least one of the impedances of the series arrangement of impedances. Many feedback circuits have a series arrangement of impedances which determine the provided feedback signal. Connecting another impedance in parallel to one of the impedances is an effective and also efficient solution to influence the operation of the feedback circuit thereby controlling the mode of operation of the power converter. Instead of connecting or disconnecting another impedance in parallel to one of the impedances, one of the impedances may be short-circuit by the power converter controller. In an embodiment, the impedances are resistors.

In an embodiment, the power converter supplies an average power in the first mode, and a peak power in the second mode. The peak power is larger than the average power. In a further embodiment the power converter is configured for operating only temporarily in the second mode. The signal processing circuit that processes the video signal and/or the audio signal of course operates in dependence on the video signal and/or the audio signal. During the normal operation of the signal processing circuit, the video signal is displayed and/or the audio signal is made audible. Video signals and/or audio signals have, in general, short intervals during which the intensity of the video frames or the amplitude of the audio signal is at a maximum level and as such the signal processing circuit will require only during short intervals the peak power level from the power converter. Thus, the power converter has to deliver the peak power only during short intervals, which allows the reduction of dimensions of components of the power converter. The size of the components may be dimensioned mainly for the amount of generated heat in the first mode. Although the components of the power converter have to be dimensioned for the largest possible voltages, and the largest possible currents, the power converter may be build more compact because of less heat generation in the power converter.

In another embodiment the power converter comprises a series arrangement of a power factor correction circuit and a main power converter. The main power converter provides power to the signal processing circuit. The power factor correction circuit comprises an average power factor correction circuit for transferring the average power in both the first mode and the second mode. The power factor correction circuit further comprises a peak power factor correction circuit for transferring an excessive power required above the average power in the second mode. The power converter controller activates the peak power factor correction circuit in the second mode and inactivates the peak power conversion circuit in the first mode. By only activating the peak power factor correction circuit in the second mode, power losses in the peak power factor correction circuit are prevented when the peak power factor correction circuit does not necessarily have to operate to deliver power. Further, the average power factor correction circuit has only to be optimized for the transfer of the average power, which results in a very efficient average power factor correction circuit with regard to energy efficiency, size and costs.

In a further embodiment, the average power factor correction circuit comprises a passive mains harmonic coil, and the peak power factor correction circuit comprises an active boost converter. Especially the use of a passive mains harmonic coil in the average power factor correction circuit is advantageous, because such a power factor correction circuit may be cheap and small. Only the relative small and cheap passive harmonics coil is required because of the relative small amount of power that has to be transferred by the average power factor correction circuit. In another embodiment the average power factor correction circuit and the peak power factor correction circuit both comprise an active boost converter.

In an embodiment, the power converter comprises a series arrangement of a power factor correction circuit and a main power converter. The main power converter provides power to the signal processing circuit. The main power converter comprises an average main power converter and a peak main power converter. The average main power converter transfers the average power in both the first mode and the second mode. The peak main power converter transfers an excessive power required above the average power in the second mode. The processing unit activates the peak main power converter in the second mode and inactivates the peak main power converter in the first mode. By only activating the main power converter in the second mode, power losses in the peak main power converter are prevented when the peak main power converter is not required to deliver power. Further, the average main power converter has only to be optimized for the transfer of the average power, which results in a very efficient average main power converter with regard to energy efficiency, size and costs.

In an embodiment, the power converter comprises a series arrangement of a power factor correction circuit and a main power converter. The main power converter provides power to the signal processing circuit. The main power converter comprises an inductance and a current sensor, the main power converter further comprises a switch, a feedback circuit and a switch controller. The switch generates a periodically varying current through the inductance. The feedback circuit provides a feedback signal related to the current through the inductance which is sensed by the current sensor. The switch controller controls the switch in response to the feedback signal. The power converter controller changes the operation of the feedback circuit to control the power converter to operate in the first mode or in the second mode. The current sensor senses the current through the inductance and the switch is controlled based on the sensed current. The current is sensed to detect how much power is stored in the inductance. The switch controller controls the switch to store a specific amount of power in the inductance in an interval during which the switch is closed. In alternating intervals the switch is kept closed and the switch is kept open. By influencing the operation of the feedback circuit, the power converter controller indirectly influences the amount of energy stored in the inductance. If more power is stored in the inductance during the interval that the switch is closed, more power may be transferred by the power converter. Changing the operation of the feedback circuit is an effective an efficient way of controlling the mode in which the power converter operates. The current sensor may be an impedance, resistor, or, for example, a current sense transformer.

In another embodiment, the feedback circuit comprises a series arrangement of impedances to tap-in the voltage across the current sensor, or the output voltage of the power converter, or the output voltage of the power factor correction circuit. The power converter controller changes the operation of the feedback circuit by connecting another impedance in parallel to at least one of the impedances of the series arrangement of impedances. Many feedback circuits have such a series arrangement of impedances which determines what kind of feedback signal is provided. Connecting another impedance in parallel to one of the impedances is an effective and also efficient solution to influence the operation of the feedback circuit thereby controlling the mode of operation of the power converter. Instead of connecting or disconnecting another impedance in parallel to one of the impedances, one of the impedances may be short-circuit by the power converter controller. In an embodiment, the impedances are resistors.

According to a second aspect of the invention, a signal processing system is provided. The signal processing system comprises the power converter system according to the first aspect of the invention, a power analyzing circuit and a signal processing circuit. The power analyzing circuit analyzes the power that is provided by the power converter and generates a further power signal that is related to the provided power. The signal processing circuit processes the signal. The signal processing circuit receives at least one of the group of the power signal and the further power signal. The signal processing circuit processes the signal in dependence on the further power signal. Or the signal processing circuit detects deviations between the power signal and the further power signal and the processing of the signal is performed in dependence on the power signal and the detected deviations.

If a power converter system according to this aspect of the invention is used, the signal processing circuit has to take into account the amount of provided power to guarantee a correct processing of the signal. Examples are amplifiers that adapt the gain of the amplifier in dependence on the provided power. The gain is adapted on basis of the power signal, which basically is a signal that requests a specific amount of provided power. If, however, the power converter system is not able to exactly provide the requested amount of power, the gain is wrongly controlled and as such the amplifier generates an amplified signal which is a distorted (audio) signal. The actual provided amount of power is subject to rise and fall times of the power supply voltage. It has been found that the rise and fall times may vary under different load conditions, different signal characteristics and characteristics of the power converter.

The signal processing system provides a power analyzing circuit which generates a further power signal which is received by the signal processing system such that the signal processing system has knowledge about the actual provided power by the power supply. The signal processing circuit uses the provided power signal to detect deviations between the requested amount of power and the actual provided amount of power. If there are deviations, the processing of the signal is adapted such that care is taken of the deviations and errors in the processing of the signal that originate from a mismatch between the expected provided power and the actual provided power are prevented. In another embodiment, the further power signal is directly used to influence the processing of the signal such that the actual provided amount of power is directly taken into account.

It is to be noted that the power analyzing circuit may analyze the actual provided voltage, the actual provided current, or the combination of the actual provided voltage and actual provided current. The processing of the signal may depend on the voltage, the current, or the combination of the voltage and the current that are indicated by the power signal and/or the further power signal. The power analyzing circuit may be a separate component of the signal processing system or, alternatively, it may be a part of the signal processing circuit.

According to a third aspect of the invention, a flat panel display apparatus is provided. The flat panel display apparatus comprises an LCD device and a power converter system according to the first aspect of the invention. The LCD device presents video information and comprises a backlight unit and a backlight controller to control an intensity of light emitted by the backlight unit in response to an intensity signal. The power converter of the system provides power to at least the backlight unit. The analyzing circuit analyzes at least the video signal which comprises the video information and the analyzing circuit generates the intensity signal as the power signal.

According to a fourth aspect of the invention, an audio system is provided. The audio system comprises an amplifier and a power converter system according to the first aspect of the invention. The amplifier amplifies an audio signal. The power converter provides power to at least the amplifier. The analyzing circuit analyzes at least the audio signal and generates a power signal indicating the power consumption of the amplifier.

In an embodiment of the audio system, the analyzing circuit generates the power signal to indicate a supply voltage that has to be supplied to the amplifier and the power converter controller controls the power converter to supply the supply voltage that is indicated by the power signal. The audio system further comprises a supply voltage analyzing circuit that analyzes the supply voltage that is provided by the power converter and which generates a further power signal being related to the provided supply voltage. The amplifier i) receives at least one of the group of the power signal and the further power signal, and iia) adapts the gain of the amplifier in dependence on the further power signal, and iib) detects deviations between the power signal and the further power signal, and adapts the gain of the amplifier in dependence on the power signal and the detected deviations.

According to a fifth aspect of the invention, a method of operating a system is provided. The system comprises a power converter and a power converter controller. The power converter receives a mains voltage and provides power to a signal processing circuit. In a first mode the power converter is able to provide a first power level and in a second mode the power converter is able to provide a second power level that is higher than the first power level. The method comprises the subsequent steps. The signal processed by the signal processing circuit is analyzed. A power signal is generated which indicates a power consumption of the signal processing circuit when the signal processing circuit is in normal operation. The power signal is provided to the power converter controller. The power converter controller controls the power converter to operate in the first mode when the power signal indicates that the power consumption of the signal processing circuit is above the first power level. The power converter is controlled to operate in the second mode when the power signal indicates that the power consumption of the signal processing circuit is above the first power level.

The signal processing system according to the second aspect of the invention, the flat panel display apparatus according to the third aspect of the invention, the audio system according to the fourth aspect of the invention, and the method according to the fifth aspect of the invention, provide the same benefits as the system according to the first aspect of the invention.

These and other aspects of the invention are apparent from and will be elucidated with reference to the embodiments described hereinafter. It will be appreciated by those skilled in the art that two or more of the above-mentioned embodiments, implementations, and/or aspects of the invention may be combined in any way deemed useful. Modifications and variations of the system and/or the method, which correspond to the described modifications and variations of the system, can be carried out by a person skilled in the art on the basis of the present description.

### BRIEF DESCRIPTION OF THE DRAWINGS

Fig. 1 schematically shows an embodiment of a power converter system in accordance with the first aspect of the invention,
Fig. 2 schematically shows an embodiment of a power converter system to provide in different modes different voltage levels to a signal processing circuit,
Fig. 3 schematically shows an embodiment of a power converter system which comprises a power converter which comprises a power factor correction circuit and a main power converter,
Fig. 4 schematically shows an embodiment of a power converter system which comprises a power factor correction circuit to provide a first voltage level or a second voltage level to a main power converter of the system,
Fig. 5 schematically shows an embodiment of a power converter system in which the output voltage level of the power factor correction circuit may be controlled on a continuous scale,
Fig. 6 schematically shows an embodiment of a power converter system in which a maximum inductance current is controlled in response to a power signal,
Fig. 7 schematically shows an embodiment of a flat panel display apparatus according to the third aspect of the invention,
Fig. 8a schematically shows an embodiment of an audio system according to the fourth aspect of the invention,
Fig. 8b shows in a graph an amplified audio signal and an input voltage level of the amplifier,
Fig. 9 schematically shows a signal processing system according to the second aspect of the invention,
Fig. 10a schematically shows another embodiment of an audio system,
Fig. 10b shows a chart in which some of the signals of the audio system of Fig. 10a are drawn, and
Fig. 11 schematically shows an embodiment of a method according to the fifth aspect of the invention.

It should be noted that items denoted by the same reference numerals in different Figures have the same structural features and the same functions, or are the same signals. Where the function and/or structure of such an item have been explained, there is no necessity for repeated explanation thereof in the detailed description.

### DETAILED DESCRIPTION OF EMBODIMENTS

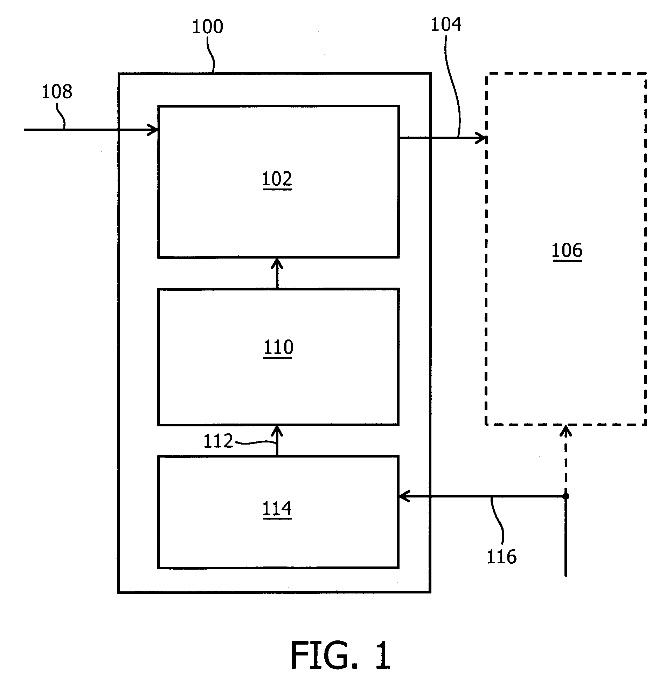

A first embodiment is shown in Fig. 1. Fig. 1 schematically shows a power converter system 100 which comprises a power converter 102, a power converter controller 110 and an analyzing circuit 114. The power converter 102 receives a mains voltage 108 and provides power 104 to a signal processing circuit 106 which is in normal operation. The power converter 102 may either operate in a first mode in which a first power level is provided to the signal processing circuit 106, or operate in a second mode in which a second power level is provided to the signal processing circuit 106. The signal processing circuit 106 processes an audio signal 116 and/or a video signal 116. The analyzing circuit 114 receives and analyzes the audio signal 116 and/or the video signal 116 to generate a power signal 112. The power signal 112 indicates the power consumption of the signal processing circuit 106. The power signal 112 is received by the power converter controller which controls the power converter 102 to operate in the first mode when the power signal 112 indicates that the power use of the signal processing circuit 106 is below the first power level, or to operate in the second mode when the power signal 112 indicates that the power use of the signal processing circuit 106 is above the first power level.

As an example, the signal processing circuit 106 may be an amplifier which amplifies an audio signal 116. The amplified audio signal is provided to a loudspeaker. The amplitude of the audio signal 116, which is an input to the signal processing circuit 106, determines how much power the amplifier consumes when amplifying the audio signal 116. In the example, the analyzing circuit 114 has knowledge about the relation between the amplitude of the audio signal 116 and the power consumption of the amplifier, and generates on basis of this knowledge the power signal 112. The knowledge may be programmed in a computer program which is executed by a processor of the analyzing circuit 114, or may be hardcoded in the hardware of the analyzing circuit 114. It is to be noted that the signal processing circuit 106 may also or alternatively comprise a video display of which the consumed power level depends on the information in the video signal 116. In a general example, the signal processing circuit 106 is a circuit of which the power consumption depends on one or more characteristics of the audio signal 116 and/or the video signal 116 which are or is processed by the signal processing circuit 106.

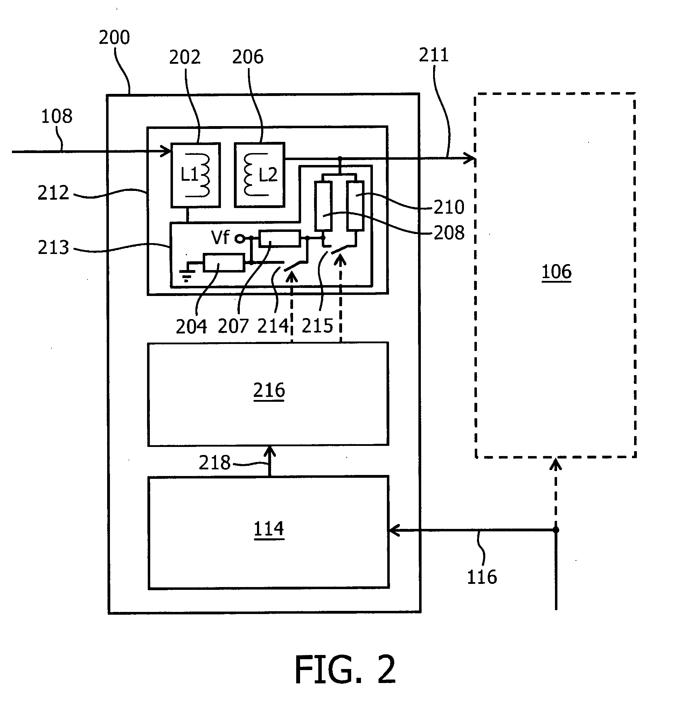

Fig. 2 schematically shows another embodiment 200 of a power converter system. The power converter system 200 comprises a power converter 212, a power converter controller 216 and an analyzing circuit 114. The power converter receives a mains voltage 108 and provides an output voltage 211 to a signal processing circuit 106 that processes an audio signal 116 and/or a video signal 116. The power converter comprises a primary side 202 which comprises a primary winding L1 of a transformer, and comprises a secondary side 206 which comprises a secondary winding L2 of the transformer. The secondary side 206 provides the output voltage 211. The power converter 212 further comprises a feedback circuit 213 for providing feedback of the output voltage 211 level from the secondary side 206 to the primary side 202. The feedback received by the primary side 202 is used to stabilize the output voltage 211 to a specific voltage level. In the embodiment shown, the feedback circuit 213 comprises a series arrangement of impedances 204, 207, 208 which taps-in the output voltage 211. Another impedance 210 is provided which may be connected in parallel to one of the impedances 208 by means of a first switch 215. A second switch 214 may be used to short-circuit one of, or part of, the impedances 207. The power converter controller 216 may close the first switch 215 and/or the second switch 214. The feedback provided to the primary side may depend on a voltage level of the point indicated by *Vf* in-between two of the impedances 204, 207. The impedances 204, 207, 208, 210 divide the output voltage 211 to obtain the feedback voltage level *Vf.* Depending on the state of the switch 214 and of the switch 215 the set of impedances 204, 207, 208, 210 divide the output voltage by one of four different division factors. As such, four different types of feedback may be provided to the primary side 202 and four different stabilized output voltages may be obtained. The state of switch 214 and switch 215 is controlled by the power converter controller 216 which results in the controlling of the power converter 212 to operate in one of four different possible modes and thus providing one of the four different stabilized voltage levels 211. The power converter controller 216 receives from the analyzing circuit a power signal 218 which indicates the voltage which is required by the signal processing circuit 106 to process the audio and/or video signal 116.

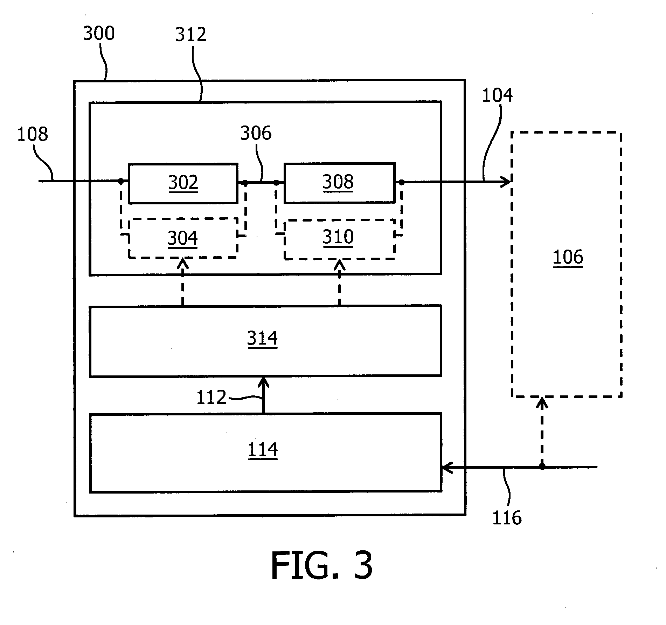

Fig. 3 schematically shows another embodiment 300 of a power converter system. The power converter system 300 comprises a power converter 312, a power converter controller 314 and an analyzing circuit 114. The analyzing circuit receives an audio signal 116 and/or a video signal 116. The audio signal 116 and/or the video signal 116 is also received by a signal processing circuit 106, which processes the audio signal 116 and/or the video signal 116. A power consumption of the signal processing circuit 106 in normal operation depends on characteristics of the audio signal 116 and/or the video signal 116. The analyzing circuit generates a power signal 112 which indicates the power consumption of the signal processing circuit 106 in normal operation. The power converter controller 314 receives the power signal 112 and controls the power converter 312 to operate in a first mode or in a second mode. The power converter 312 receives the mains voltage 108 and provides power 104 to the signal processing circuit 106. The power converter 312 is able to provide an average power level when operating in the first mode and is able to provide a peak power level when operating in the second mode. The peak power level is higher than the average power level.

The power converter comprises a series arrangement of a power factor correction circuit 302 and a main power converter 308. The power factor correction circuit 302 corrects the power factor of the power converter 312 and provides a specific voltage 306 to the main power converter 308.

In an embodiment, the power converter further comprises a peak power factor correction circuit 304. The power factor correction circuit 302 is able to provide an average amount of power to the main power converter 308 and the peak power factor correction circuit 304 is able to provide additional power above the average power level when the consumed power of the signal processing circuit 106 is above the average power level. The power converter controller 314 controls the peak power factor correction circuit 304 to be only active when the power converter 312 has to operate in the second mode. The power converter 312 has to operate in the second mode when the power signal 112 indicates that the power consumption of the signal processing circuit 106 is above the average power level. In one embodiment the power factor correction circuit 302 and the peak power factor correction circuit 304 may both be a boost converter. In another embodiment the power factor correction circuit 302 is a series arrangement of a passive mains harmonic coil and a rectifier circuit for correcting the power factor, and the peak power factor circuit 304 is a boost converter. The rectifier circuit is, for example, a diode.

In another embodiment, the main power converter 308 is able to transfer the average power level. The power converter 312 further comprises a peak main power converter 310 which is capable of transferring additional power which is required above the average power when the power converter 312 is operating in the second mode. The power converter controller 314 controls the power converter 312 to operate in the first mode or in the second mode by respectively inactivating or by activating the peak main power converter 310. Activating the peak main power converter 310 may be done by switching on the peak main power converter 310 or connecting the peak main power converter 310 to the specific voltage 306 provided by the power factor correction circuit 302.

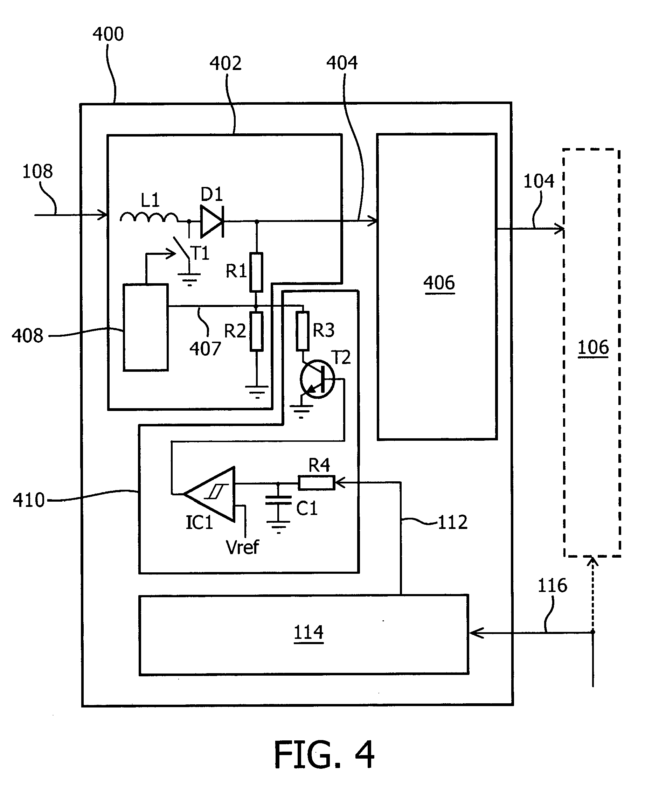

Fig. 4 schematically shows another embodiment 400 of a power converter system. The power converter system 400 comprises a power converter which has a power factor correction circuit 402 and a main power converter 406. The power converter system further comprises a power converter controller 410 and an analyzing circuit 114. The power factor correction circuit 402 receives the mains voltage 108 and provides a voltage 404 to the main power converter 406. The power factor correction circuit 402 is able to operate in a first mode or in a second mode. In the first mode the power factor correction circuit 402 provides a first voltage level to the main power converter 406, and in the second mode the power factor correction circuit 402 provides a second voltage level being higher than the first voltage level. The main power converter 406 is able to transfer more power when it receives a higher voltage 404 from the power factor correction circuit 402. The power 104 provided by the main power converter is consumed by a signal processing circuit 106 that processes a video signal 116 and/or an audio signal 116 in normal operation. Additionally, the main power converter may supply power to other circuit than the signal processing circuit 106.

The power factor correction circuit 402 comprises a boost converter. The boost converter comprises a series arrangement of an inductance L1 and a diode D1. The boost converter further comprises a controllable switch T1, a switch controller 408 and a series arrangement of two impedances R1 and R2. The series arrangement of the inductance L1 and the diode D1 provide the output voltage 404. The series arrangement of two impedances R1 and R2 divide the output voltage and provide a voltage feedback signal 407 to the switch controller 408. The impedances R1 and R2 may be resistors. The switch controller 408 controls the switch T1 such that the output voltage 404 is stabilized.

The power converter controller 410 receives a power signal 112 indicating a power consumption of the signal processing circuit 106 in normal operation and controls the power factor correction circuit 402 to operate in the first mode or in the second mode by connecting an impedance R3 in parallel to the impedance R2 of the power factor correction circuit 402. The power signal 112 is processed by a Schmitt trigger integrated circuit IC1. The Schmitt trigger integrated circuit compares a voltage level of the power signal 112 with a reference voltage and as a result of the comparison a transistor T2 is switched into a conducting or a non-conducting state. If the transistor T2 is conducting, impedance R3 is connected in parallel to impedance R2.

The voltage division of the voltage 404 by the series arrangement of impedances R1 and R2 changes when the impedance R3 is connected and the value of the voltage feedback signal 407 changes. Consequently, the switch controller controls the switch such that another stabilized output voltage level is obtained.

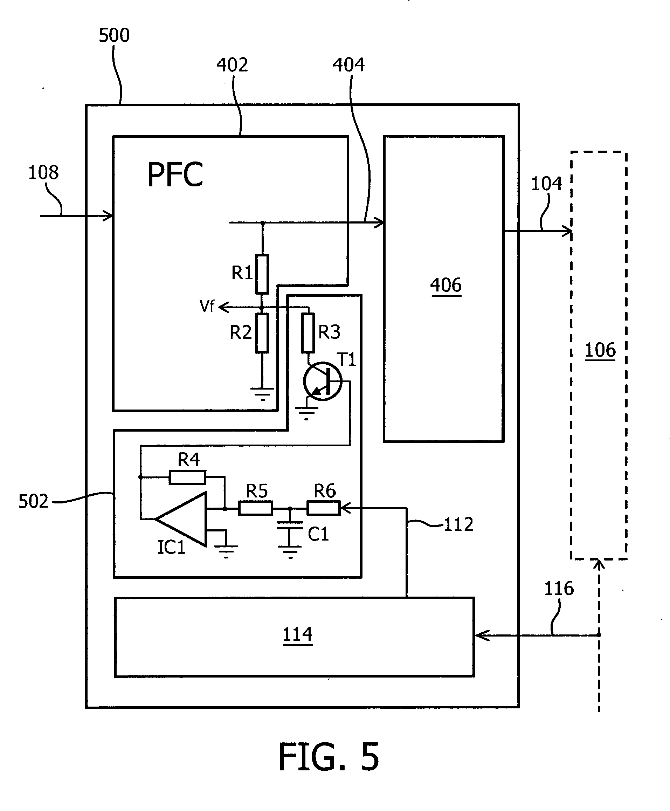

Fig. 5 schematically shows the same components as Fig. 4, but the power converter controller 502 is arranged differently. The shown implementation of the power converter controller 502 controls the conductivity of transistor T1 on a continuous scale instead of controlling the conductivity of transistor T1 in two discrete states, which is the case in the implementation of Fig. 4. The impedance R3 and the transistor T1 form together an impedance of which the value varies on a continuous scale. As such the output voltage 404 of the power factor correction circuit 402 may be varied on a continuous scale, and as such the main power converter 406 is able to transfer a varying amount of power.

The transistor T1 is driven by a signal that it receives from an opamp IC1. The opamp IC1 forms together with resistors R4 and R5 an amplifier which amplifies or attenuates the power signal 112. Capacitance C1 and resistor R6 form an input impedance circuit.

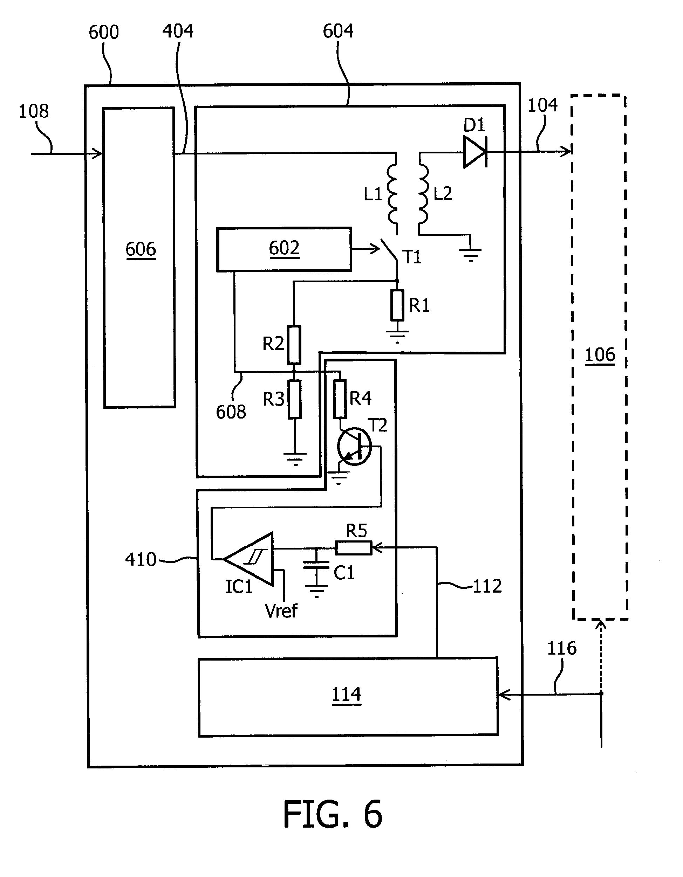

Fig. 6 shows another embodiment 600 of a power converter system. The power converter system 600 comprises a power converter which comprises a power factor correction circuit 606 and a main power converter 604. The system 600 further comprises a power converter controller 410 and an analyzing circuit 114. The analyzing circuit 114 and the power converter controller 410 have the same characteristics as the analyzing circuit 114 and the power converter controller 410 of Fig. 4.

The power converter system 600 provides power 104 to a signal processing circuit 106 which processes a video signal 116 and/or an audio signal 116. A power consumption of the signal processing circuit 106 in normal operation depends on characteristics of the video signal 116 and/or the audio signal 116.

The main power converter 604 comprises a flyback converter. The flyback converter comprises a primary side and a secondary side. Only a secondary winding L2 of a transformer and a diode D1 of the secondary side are shown. The secondary side provides the power 104. The primary side comprises a primary winding L1 of the transformer, a controllable switch T1, a current sense resistor R1, a series arrangement of two resistors R2 and R3 and a switch controller 602. The switch T1 periodically varies the current through the primary winding L1. A voltage across the current sense resistor R1 relates to the current through the primary winding L1. The series arrangement of the two resistors R2 and R3 acts as a voltage division circuit to divide the voltage across the current sense resistor R1 to obtain a current sense signal 608 which is provided to the switch controller 602. The switch controller 602 uses the current sense signal 608 to decide when the switch T1 needs to be opened.

At the instant that the switch T1 is closed, the current through the inductance starts to increase and (magnetic) energy is stored in the transformer. As soon as enough energy is stored in the transformer, which may be detected by a high enough voltage across the current sense resistor R1, the switch T1 is opened by the switch controller 602. The energy stored in the transformer is transferred to the secondary side for providing power 104 to the signal processing circuit 106. Thus, the amount of energy stored in the transformer has a strong relation with the amount of power 104 that the power converter can provide. Influencing the amount of energy that is stored in the transformer during the interval during which the switch T 1 is closed, influences the amount of power 104 the power converter is able to deliver.

The current sense signal 608 is obtained from a junction of the resistors R2 and R3. They form a voltage division network to divide the voltage across the current sense resistor R1. The division factor of voltage division network is changed by connection another resistor R4 in parallel to resistor R3 thereby obtaining another voltage division factor, which result in another amount of energy that is stored in the transformer during the interval in which the switch T1 is closed. The power converter controller 410 uses T2 to connect or disconnect resistor R4 and thereby the power converter controller 410 is able to control the main power converter 604 to transfer a first power level or a second power level. Of course, the division factor may be changed in the same manner by influencing the impedances involved in another manner.

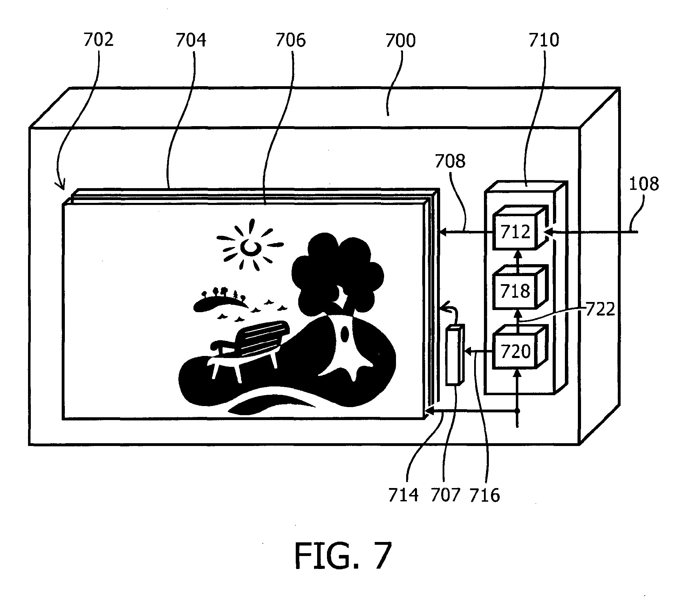

Fig. 7 schematically shows a flat panel display apparatus 700 according to the third aspect of the invention. The flat panel display apparatus 700 comprises an LCD device 702 and a system 710 in accordance with the first aspect of the invention. The LCD device 702 comprises a backlight unit 704, a backlight controller 707, and a liquid crystal display 706. The backlight unit 704 emits light of a controllable intensity towards the liquid crystal display 706. The backlight controller 707 controls the intensity of the light emitted by the backlight unit 704 in response to a received intensity signal 716. The liquid crystal display 706 comprises liquid crystal cells for filtering the light received from the backlight before emitting the light towards a user of the flat panel display apparatus 700.

The system 710 of the flat panel apparatus 700 comprises an analyzing circuit 720, a power converter controller 718 and a power converter 712. The power converter receives a mains voltage 108 and converts the mains voltage 108 to another voltage level and provides power 708 of the other voltage level to at least the backlight unit 704. Depending on the intensity that is emitted by the backlight unit 704, the backlight unit 704 consumes a specific amount of power.

The liquid crystal cells are controlled in response to a received video signal 714. If a specific liquid crystal cell has to emit a specific intensity, the intensity of the light emitted by the backlight 704 is partly absorbed by the liquid crystal cell to obtain the specific intensity. If all liquid crystal cells have to absorb some light, it is more efficient to control the intensity of the light of the backlight unit 704 to a lower level and control the liquid crystal cells to absorb less light. The video signal 714 is analyzed by the analyzing circuit 720 to determine at which intensity level the backlight unit 704 has to emit light. For example, the video signal of an interval of time is analyzed to determine the maximum intensity of all the pixels of all the video frames of the interval. The determined maximum intensity may be the intensity at which the backlight unit 704 emits light during the interval during which the video frames are presented to the user of the flat panel display apparatus 700. The determined intensity level for the backlight unit is provided to the backlight controller by means of the intensity signal 716.

The analyzing circuit 720 further generates a power signal 722 which indicates the power consumption of the backlight unit 704 in normal operation during the interval. The analyzing circuit 720 has build-in-knowledge about the relation between the emitting intensity of the backlight unit 704 and the power consumption of the backlight unit 704. The build-in-knowledge may be a pre-coded table or a function, and the pre-coded table or the function may be implemented by means of hardware or software.

The power signal 722 is provided to the power converter controller 718 which controls the power converter 712 to operate in a first mode or in a second mode. In the first mode the power converter 712 is able to provide power 708 of a first power level and in the second mode the power converter 712 is able to provide power 708 of a second power level, which is higher than the first power level. Embodiments of such power converters are discussed previously. If the power signal 722 indicates that the power consumption of the backlight unit 704 is below the first power level, the power converter controller 718 controls the power converter 712 to operate in the first mode. If the power signal 722 indicates that the power consumption of the backlight unit 704 is above the first power level, the power converter 712 is controlled to operate in the second mode. It has to be noted that both modes are normal operating modes wherein an image is displayed, and that the video signal is analyzed to control the selection of the actual mode of operation of the power converter.

The flat panel display apparatus 700 is very efficient. Firstly because the intensity of the backlight unit 704 is reduced when the intensity of the pixels in the video frames are lower than the maximum intensity. Secondly because the power converter 712 is always operating most efficiently with regard to the provided power level in the first mode or in the second mode. Further, the dimensions of the power converter 812 may be small and cheap because the power converter 712 may be dimensioned on basis of the fact that most of the time only the first power level has to be provided by the power converter 712 to the backlight unit 704, and that only during relative short intervals of time the backlight unit 704 consumes more than the first power level if the video signal 714 has some subsequent frames in which the pixels have a high intensity level.

It is to be noted that the backlight unit 704 may be split into a plurality of zones, and that the light intensity emitted by the plurality of zones may be controlled by a plurality of intensity signals 716. The analyzing circuit 720 generates the plurality of intensity signals 716 in dependence on the video signal 714, and the power signal 722 indicates the sum of the power consumptions of the respective zones of the backlight unit 704.

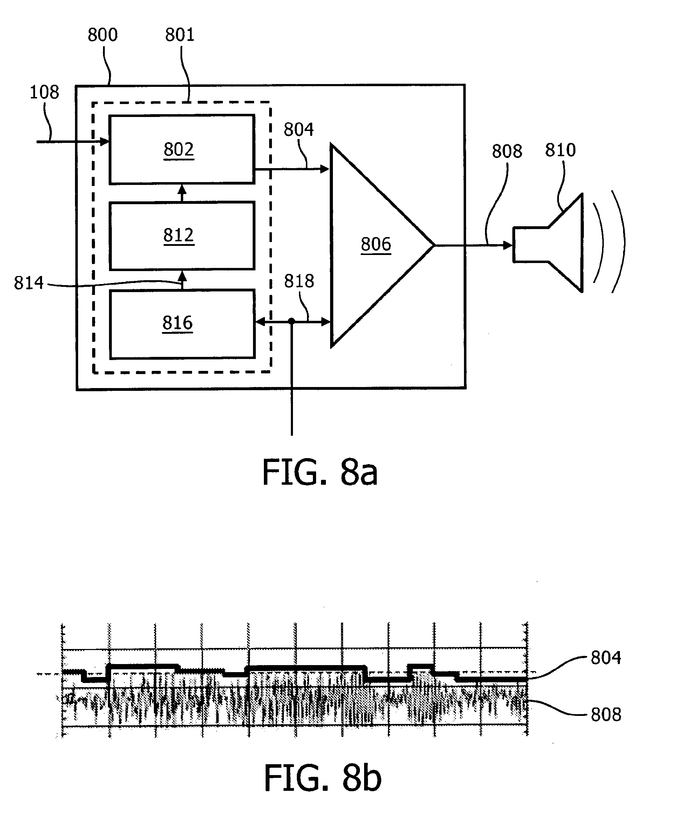

Another embodiment is presented in Fig. 8a. Fig. 8a schematically shows an audio system 800 according to the fourth aspect of the invention. The audio system 800 comprises an amplifier 806 and a power converter system 801 in accordance with the first aspect of the invention. The amplifier 806 receives an audio signal 818 and generates an amplified audio signal 808 which is provided to one or more loudspeakers 810. The amplifier receives a supply voltage 804 from a power converter 802 of the power converter system 801. The power converter 802 transforms a mains voltage 108 to the supply voltage 804. The supply voltage 804 has a specific voltage level which is sufficiently high to amplify the audio signal 818 to a required output level.

The power converter system 801 further comprises an analyzing circuit 816 and a power converter controller 812. The analyzing circuit 816 receives the audio signal 818 and analyzes the audio signal 818 in a specific interval of time to determine which supply voltage is required by the amplifier 806 to amplify the audio signal 818 of the interval of time. The required supply voltage is provided as a power signal 814 to the power converter controller 812 which controls the power converter 802 to provide the supply voltage 804 that is close to and at least the required supply voltage. The power converter 802 may operate in a plurality of modes. In each mode the power converter 802 is able to provide a specific supply voltage 804 to the amplifier 806. Embodiments for such a power converter 802 have been discussed previously. The power converter controller 812 selects the mode of which its respective supply voltage is above the required supply voltage and at the same time such that the difference between the required supply voltage and the respective supply voltage is minimized.

If the supply voltage 804 is higher, the amplifier is capable of amplifying the audio signal 818 to a higher output power level such that the loudspeaker(s) 810 may generate a louder sound. In general, known amplifiers receive a stabilized unchangeable supply voltage that has a voltage level high enough for amplifying the audio signal 818 to a defined maximum output power level. When, the input audio signal 818 has a relatively low amplitude, the amplifier does not generate an amplified audio signal 808 with an amplitude that is close to the maximum supply voltage. If the amplifier 806 receives in such situations the maximum supply voltage, the amplifier 806 does not operate efficiently, because the amplifier 806 has to create a voltage difference between the maximum supply voltage and the voltage of the output signal. Creating the voltage difference results in a relatively high power dissipation in the amplifier 806. Thus, by reducing the supply voltage 804 when the amplifier 806 does not have to amplify to the highest possible output level, the amplifier 806 operates more efficiently because the amplifier 806 does not have to create a large voltage difference between in the input supply voltage 804 and the voltage level of the amplified audio signal 808.

A graph is shown in Fig. 8b in which the levels of two signals of the audio system 800 are drawn. The wave form signal is the amplified audio signal 808. The bold line 804 is the supply voltage 804 provided by the power converter 802. It is seen in Fig. 8b that the supply voltage 804 is controlled to vary during subsequent intervals. Several supply voltage levels are provided by the power converter 802 in respective several operating modes. The supply voltage 804 is relative low or high during an interval of time in which the amplitude of the amplified audio signal 808 is relative low or relative high, respectively.

In a practical embodiment the audio signal 818 is provided to the amplifier with a delay which is long enough to analyze the audio signal 818 of an interval of time by the analyzing circuit 816, and is long enough to control the power converter 802 to operate in a desired mode. For example, if, the audio signal is analyzed for every interval of 5 ms and if the time required to provide the possibly changed desired supply voltage 804 is 1 ms, the delay has to be 6 ms.

It has to be noted that the operating modes are normal operating modes during which the audio signal should be made audible, and the audio signal is analyzed to control the selection of the actual mode of operation of the power converter.

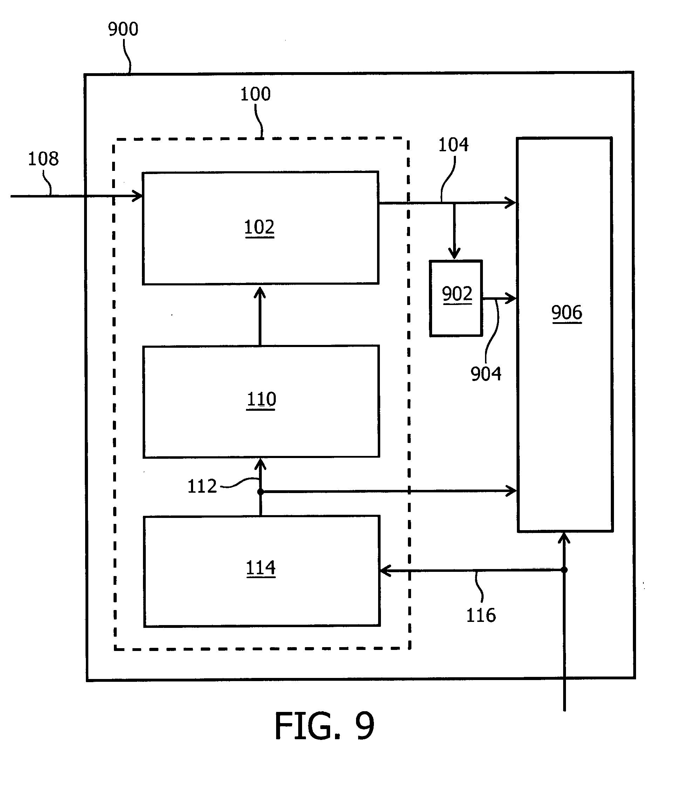

Fig. 9 schematically shows an embodiment of a signal processing system 900 according to the second aspect of the invention. The signal processing system 900 comprises a power converter system 100 that is similar to the power converter system of Fig. 1. A modification is that the power signal 112 may be provided to other circuits as well. The signal processing system 900 further comprises a signal processing circuit 906 which processes the signal 116. The signal processor circuit 906 receives power 104 from the power converter system 100. It is to be noted that the power converter system 100 may also provide power to other loads which are not presented in Fig. 9. The signal processing circuit 906 is configured to process the signal 116 in dependence on the power signal, which means that, the amount of power that is indicated by the power signal influences the processing of the signal. In specific applications such a signal processing is used because it may lead to energy savings. An example is audio amplifiers that require a lower supply voltage when the amplitude of the input audio signal is relatively small. The processing of the signal 116, which depends on the indicated amount of power of the power signal 112, has for example, parameters in the signal processing algorithms that directly depend on the indicated amount of power. If, however, the power converter 102 of the power converter system 100 does not exactly provide the indicated amount of power, the processing of the signal 116 may be erroneous. To prevent such an erroneous processing of the signal 116, the signal processing system 900 further comprises a power analyzing circuit 902 which analyzes the power 104 that is provided by the power converter 102 and generates a further power signal 904 that is related to the provided power 104. The signal processing circuit 906 receives the further power signal 904, and detects deviations between the power signal 112 and the provided power signal 904. The signal processing circuit 906 uses the detected deviations to correct the processing of the signal 116 such that a correct processing of the signal 116 is obtained. In another embodiment, the signal processing circuit 906 directly uses the further power signal 904 to adapt the processing of the signal. The power analyzing circuit 902 may be an analog or digital circuit, and the further power signal 904 may be an analog or digital signal. The power analyzing circuit 902 may monitor the voltage of the provided power 104, monitor the current of the provided power 104, or monitor the combination of the provided voltage and current. In an embodiment, the power analyzing circuit 902 is a voltage detector, which uses an analog to digital converter to generate the provided power signal that comprises the value of the voltage of the provided power 104 as a digital value. It is further noted that the analyzing circuit 114 is not necessarily part of the power converter system 100. In an embodiment, the analyzing circuit 114 is part of the signal processing circuit 906, and as such the signal processing circuit 906 generates the power signal 112 and provides the power signal 112 to the power converter controller 110.

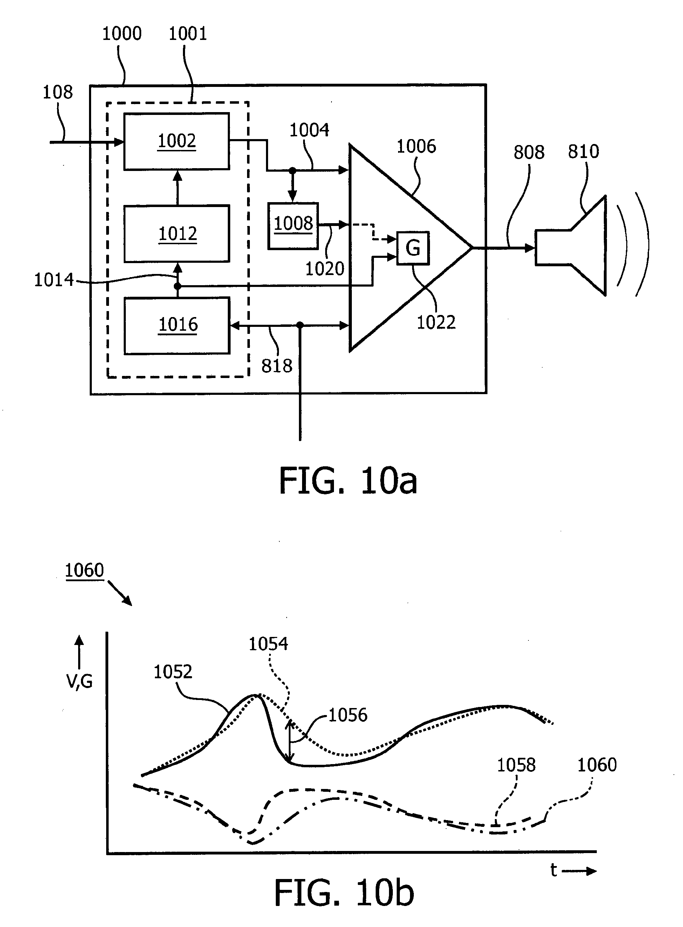

Fig. 10a shows another embodiment of the audio system of Fig. 8a. The audio system comprises a power converter system 1001 which comprises a power converter 1002, a power converter controller 1012, and an analyzing circuit 1016, and the audio system further comprises a supply voltage analyzing circuit 1008, and an amplifier 1006.

The power converter system 1001 is used to convert a mains power voltage 108 to a supply voltage 1004 for the amplifier 1006. The power converter system 1001 is a so-termed power on demand system which provides the supply voltage 1004 in dependence on a requested supply voltage which is indicated by a power signal 1014. In the embodiment of Fig.10a, the analyzing circuit 1016 generates the power signal 1014 in dependence on a received audio signal 818. In another embodiment the analyzing circuit 1016 may be part of the amplifier 1006. The power converter controller receives the power signal 1014 and controls the power converter 1002 to provide the supply voltage 1004 that is indicated by the power signal 1014. In practical embodiments the combination of the power converter controller 1012 and the power converter 1002 are not immediately able to provide the requested supply voltage. If, for example, the requested supply voltage increases with a relatively steep slope, the provided supply voltage 1004 increases as well, but with a less steep slope. The same applies to a decreasing requested supply voltage.

In the chart of Fig. 10b, solid line 1052 is an example of the requested supply voltage which changes over time, and dotted line 1054 is the actually provided supply voltage 1004. It is seen that large deviations 1056 may occur when the requested supply voltage line 1052 drops with a steep slope.

The amplifier 1006 adapts the gain of the amplifier in dependence on the supply voltage. In several types of amplifiers a lot of power is dissipated in the amplifier when the output audio signal 808 has a relatively small amplitude compared to the level of supply voltage. It may be advantageous to adapt the supply voltage to a lower level when the input audio signal 818 has a relatively small amplitude, and adapt, at the same time, the gain G of the amplifier 1006. The analyzing circuit 1016 analyzes the amplitude of the input audio signal 818 and indicates with the power signal 1014 a required supply voltage level. The power signal 1014 is also received by the amplifier 1006 that adapts the gain G accordingly.

In Fig. 10b, dashed line 1058 shows a varying gain value over time in dependence on the requested supply voltage, of which the variations are shown by line 1052.

However, when the actual provided supply voltage 1004 does not match the required supply voltage level of the power signal 1014, the gain has an incorrect value and the amplification is performed in a wrong way. It has been observed that weird sounds may be generated by the audio system if the actual provided supply voltage 1004 does not match the requested supply voltage.

The supply voltage analyzing circuit 1008 senses continuously the voltage level of the actually supplied voltage 1004 and generates a further power signal 1020 which is used by the amplifier 1006 to detect deviations between the provided supply voltage and the requested supply voltage of the power signal 1014. If there are deviations, the gain G of the amplifier 1006 is corrected accordingly. Thus, after correction, the amplifier operates correctly and does not produce erroneous sounds as the result of a mismatch between the requested voltage level and the actual provided voltage level.

In Fig. 10b the dashed-dotted line 1060 shows an example of the value of the gain G of the amplifier 1016 after correction for detected deviations.

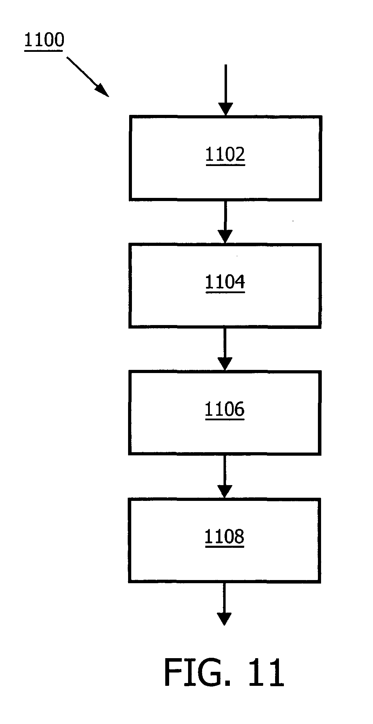

Fig. 11 schematically shows an embodiment 1100 of a method of operating a power converter system according to the fifth aspect of the invention. The power converter system comprises a power converter and a power converter controller. The power converter receives a mains voltage and provides power to a signal processing circuit which processes an audio signal and/or a video signal. The power converter is able to provide either a first power level in a first mode or a second power level in a second mode. In a first step 1102 of the method 1100 the audio signal and/or the video signal is received and analyzed. In a second step 1104, a power signal is generated which indicates a power consumption of the signal processing circuit in normal operation. In a third step 1106, the power signal is provided to the power converter controller. And in a fourth step 1108, the power converter controller controls the power converter to operate in the first mode or in the second mode. The power converter is controlled to operate in the first mode when the power signal indicates that the power consumption of the signal processing circuit is below the first power level. The power converter is controlled to operate in the second mode when the power signal indicates that the power consumption is above the first power level.

It should be noted that the above-mentioned embodiments illustrate rather than limit the invention, and that those skilled in the art will be able to design many alternative embodiments without departing from the scope of the appended claims. Especially, in some of the embodiments the power factor correction circuit is shown as a boost converter, however, other architectures for the power factor correction circuit are possible as well. In one embodiment the main power converter is shown as a flyback converter, however, the main power converter may be implemented as, for example, a LLC resonant or full bridge power supply as well. The signal processing circuit is not limited to the examples as described. All types of circuits that process the video and/or the audio signal while being in normal operation may receive power from the system. A non-limited list of examples of such circuits is: amplifiers, radios, television sets, flat panel plasma display, LCD displays, OLED displays, beamers, signal processing systems, mobile phones, audio / video signal transmitters or receivers of transmitted audio / video signals. Further, the embodiments are not limited to a first power level and a second power level. A plurality of levels may be used by the system, or the value of the power level provided to the signal processing circuit may be controlled on a continuous scale. Further, the system provides a specific power level to the signal processing circuit, which means that the signal processing circuit provides a specific voltage level, or a specific current level or a combination of a specific voltage level and a specific current level to the signal processing circuit.

In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. An apparatus (700) comprising:
- an audio and/or video processing circuit (106), and
- a power converter (102, 212, 312, 712, 802) for receiving a mains voltage (108) and for providing power (104, 708) to the audio and/or video processing circuit (106), **characterized in that** the power converter (102, 212, 312, 712, 802) is configured for operating in at least two modes, a first mode in which the power converter (102, 212, 312, 712, 802) is able to supply a first power level, and a second mode in which the power converter is able to supply a second power level that exceeds the first power level, and **in that** the apparatus comprises:
- an analyzing circuit (114, 720, 816) for analyzing an audio and/or video signal (116, 818) processed by the audio and/or video processing circuit (106) for generating a power signal (112, 716, 814) indicating a power consumption of the audio and/or video processing circuit (106) in normal operation, and
- a power converter controller (110, 216, 314, 410, 502, 718, 812) for receiving the power signal (112, 716, 814) and for controlling the power converter (102, 212, 312, 712, 802) to
i) operate in the first mode when the power signal (112, 716, 814) indicates that the power consumption of the audio and/or processing circuit (106) is below the first power level, or
ii) operate in the second mode when the power signal (112, 716, 814) indicates that the power consumption of the audio and/or video processing circuit (106) is above the first power level.

2. An apparatus (700) according to claim 1, wherein the power signal (112, 716, 814) indicates the power consumption of the audio and/or video processing circuit (106) expected to be consumed during a time interval succeeding an instant at which the power signal is received.

3. An apparatus (700) according to claim 1, wherein
- the power converter (102, 212, 312, 712, 802) is configured for operating in one of a plurality of modes, including the first mode and the second mode, wherein in each one of the plurality of modes the power converter (102, 212, 312, 712, 802) is able to supply a specific one of a plurality of power levels, and
- the power converter controller (110, 216, 314, 410, 502, 718, 812) is configured for controlling the power converter (102, 212, 312, 712, 802) to operate in one of the plurality of modes which best matches the power consumption indicated by the power signal (112, 716, 814).

4. An apparatus (700) according to claim 1, wherein
- the power converter (102, 212, 312, 712, 802) is configured for providing an output voltage (211, 804) to the audio and/or video processing circuit (106), the output voltage having a first output voltage level in the first mode and a second output voltage level exceeding the first output voltage level in the second mode,
- the analyzing circuit (114, 720, 816) is configured to generate the power signal (112, 716, 814) indicating an input voltage level required by the audio and/or video processing circuit (106) in normal operation, and
- the power converter controller circuit (110, 216, 314, 410, 502, 718, 812) is configured for controlling the power converter (102, 212, 312, 712, 802) to:
i) operate in the first mode when the indicated input voltage level is below the first output voltage level, or
ii) operate in the second mode when the indicated input voltage level is above the first output voltage level.

5. An apparatus (700) according to claim 4, wherein
- the power converter (102, 212, 312, 712, 802) comprises a primary side for receiving the mains voltage (108), a secondary side for providing the output voltage (211, 804), and a feedback circuit (213) for providing feedback to the primary side, which feedback is related to the output voltage level, to control at the primary side a power transfer to the secondary side for stabilizing the output voltage (211, 804) at a specific level, and
- the power converter controller (110, 216, 314, 410, 502, 718, 812) is configured for changing the operation of the feedback circuit (213) to control the power converter (102, 212, 312, 712, 802) to operate in the first mode or in the second mode.

6. An apparatus (700) according to claim 1, wherein
- the power converter (102, 212, 312, 712, 802) comprises a series arrangement of a power factor correction circuit (402, 606) and a main power converter (406, 604) for providing power to the audio and/or video processing circuit (106),
- the power factor correction circuit (402, 606) is configured for supplying to the main power converter (406, 604), in response to the power signal (112, 716, 814), in the first mode a first voltage, and in the second mode a second voltage exceeding the first voltage.

7. An apparatus (700) according to claim 1, wherein the power converter (102, 212, 312, 712, 802) is configured for supplying an average power in the first mode and a peak power being larger than the average power in the second mode.

8. An apparatus (700) according to claim 7, wherein
- the power converter (102, 212, 312, 712, 802) comprises a series arrangement of a power factor correction circuit (402, 606) and a main power converter (406, 604) for providing power to the audio and/or video processing circuit (106),
- the power factor correction circuit (402, 606) comprises an average power factor correction circuit (302) for transferring the average power in both the first and second mode,
- the power factor correction circuit (402, 606) comprises a peak power factor correction circuit (304) for transferring an excessive power required above the average power in the second mode, and
- the power converter controller (110, 216, 314, 410, 502, 718, 812) activates the peak power factor correction circuit (304) in the second mode and inactivates the peak power factor correction circuit (304) in the first mode.

9. An apparatus (700) according to claim 7, wherein
- the power converter (102, 212, 312, 712, 802) comprises a series arrangement of a power factor correction circuit (402, 606) and a main power converter (406, 604) for providing power to the audio and/or video processing circuit (106),
- the main power converter (406, 604) comprises an average main power converter (308) for transferring the average power in both the first mode and second mode,
- the main power converter (406, 604) comprises a peak main power converter (308) for transferring an excessive power required above the average power in the second mode, and
- the power converter controller (110, 216, 314, 410, 502, 718, 812) activates the peak main power converter (308) in the second mode and inactivates the peak main power converter (308) in the first mode.

10. An apparatus (700) according to claim 1, wherein
- the power converter (102, 212, 312, 712, 802) comprises a series arrangement of a power factor correction circuit (402, 606) and a main power converter (406, 604) for providing power to the audio and/or video processing circuit (106),
- the main power converter (406, 604) comprises
i) an inductance (L1) and a current sensor (R1),
ii) a switch (T1) for generating a periodically varying current through the inductance (L1),
iii) a feedback circuit for providing a feedback signal related to the current through the inductance (L1) being sensed by a voltage across the current sensor (R1), and
iv) a switch controller (602) for controlling the switch (T1) in response to the feedback signal,
- the power converter controller (110, 216, 314, 410, 502, 718, 812) is configured for changing the operation of the feedback circuit to control the power converter (102, 212, 312, 712, 802) to operate in the first mode or in the second mode.

11. An apparatus (700) according to claim 1 comprising a signal processing system (900) comprising
- a power analyzing circuit (902) for analyzing the power (104) that is provided by the power converter (102, 212, 312, 712, 802) and for generating a further power signal (904) being related to the provided power (104),
- a audio and/or video processing circuit (906) for processing the signal (116, 818), the audio and/or video processing circuit (906) being configured
i) to receive at least one of the group of the power signal (112, 716, 814) and the further power signal (904), and
iia) to process the signal (116, 818) in dependence of the further power signal (904), or
iib) to detect deviations between the power signal (112, 716, 814) and the further power signal (904), and to process the signal (116, 818) in dependence of the power signal (112, 716, 814) and the detected deviations.

12. An apparatus (700) according to any of the previous claims, where the apparatus is a display apparatus and the audio and/or video signal is a video signal (714).

13. An apparatus according to claim 12, where the apparatus (700) comprises an LCD display device (702) for presenting video information, , the audio and/or video processing circuit comprising a backlight unit (704) and a backlight controller (707) for controlling an intensity of light emitted by the backlight unit (704) in response to the power signal.

14. An apparatus according to any of claims 1 - 11, where the apparatus comprises an audio system (800,1000), wherein the audio and/or video signal is an audio signal (108), and wherein the audio and or video processing circuit comprises an amplifier (806) for amplifying an audio signal (818).

15. A method (1100) of operating a apparatus comprising a power converter for receiving a mains voltage and for providing power to an audio and/or video processing circuit for processing an audio and/or video signal, and a power converter controller, **characterized in that** the method comprises the steps of:
- analyzing (1102) the signal,
- generating (1104) a power signal indicating a power consumption of the audio and/or video processing circuit when the audio and/or video processing circuit is in normal operation, and
- providing (1106) the power signal to the power converter controller, and
- controlling (1108) the power converter to operate
i) in a first mode when the power signal indicates that the power consumption of the audio and/or video processing circuit is below a first power level, or
ii) in a second mode when the power signal indicates that the power consumption of the audio and/or video processing circuit is above the first power level,
wherein the power converter is able to provide in the first mode the first power level and in the second mode the second power level exceeding the first power level.

## Patentansprüche

1. Vorrichtung (700), umfassend:
- eine Audio- und/oder Videoverarbeitungsschaltung (106), und
- einen Leistungswandler (102, 212, 312, 712, 802) zum Empfangen einer Netzspannung (108) und zum Liefern von Energie an die Audio- und/oder Videoverarbeitungsschaltung (106), **dadurch gekennzeichnet, dass** der Leistungswandler (102, 212, 312, 712, 802) zum Arbeiten in mindestens zwei Modi konfiguriert ist, einen ersten Modus, in dem der Leistungswandler (102, 212, 312, 712, 802) fähig ist, einen ersten Leistungspegel zu liefern, und einen zweiten Modus, in dem der Leistungswandler fähig ist, einen zweiten Leistungspegel zu liefern, der den ersten Leitungspegel überschreitet, und dass die Vorrichtung umfasst:
- eine Analyseschaltung (114, 720, 816) zum Analysieren eines von der Audio- und/oder Videoverarbeitungsschaltung (106) verarbeiteten Audio- und/oder Videosignals (116, 818) zum Erzeugen eines Leistungssignals (112, 716, 814), das einen Energieverbrauch der Audio- und/oder Videoverarbeitungsschaltung (106) im normalen Betrieb anzeigt, und
- eine Leistungswandlersteuerung (110, 216, 314, 410, 502, 718, 812) zum Empfangen des Leistungssignals (112, 716, 814) und zum Steuern des Leistungswandlers (102, 212, 312, 712, 802), um
i) in dem ersten Modus zu arbeiten, wenn das Leistungssignal (112, 716, 814) anzeigt, dass sich der Energieverbrauch der Audio- und/oder Videoverarbeitungsschaltung (106) unterhalb des ersten Leistungspegels befindet, oder
ii) in dem zweiten Modus zu arbeiten, wenn das Leistungssignal (112, 716, 814) anzeigt, dass der Energieverbrauch der Audio- und/oder Videoverarbeitungsschaltung (106) über dem ersten Leistungspegel liegt.

2. Vorrichtung (700) nach Anspruch 1, wobei das Leistungssignal (112, 716, 814) den Energieverbrauch der Audio- und/oder Videoverarbeitungsschaltung (106) anzeigt, der während eines Zeitintervalls erwartet wird, das einem Zeitpunkt folgt, zu dem das Leistungssignal empfangen wird.

3. Vorrichtung (700) nach Anspruch 1, wobei
- der Leistungswandler (102, 212, 312, 712, 802) konfiguriert ist, um in einem von mehreren Modi zu arbeiten, enthaltend den ersten Modus und den zweiten Modus, wobei in jedem der mehreren Modi der Leistungswandler (102, 212, 312, 712, 802) fähig ist, einen speziellen von mehreren Leistungspegeln zu liefern, und
- die Leistungswandlersteuerung (110, 216, 314, 410, 502, 718, 812) konfiguriert ist, um den Leistungswandler (102, 212, 312, 712, 802) zu steuern, in einem von mehreren Modi zu arbeiten, der am besten zu dem durch das Leistungssignal (112, 716, 814) angezeigten Energieverbrauch passt.

4. Vorrichtung (700) nach Anspruch 1, wobei
- der Leistungswandler (102, 212, 312, 712, 802) konfiguriert ist, um eine Ausgangsspannung (211, 804) für die Audio- und/oder Videoverarbeitungsschaltung (106) bereitzustellen, wobei die Ausgangspannung einen ersten Ausgangsspannungspegel in dem ersten Modus und einen zweiten Ausgangsspannungspegel, der den ersten Ausgangsspannungspegel überschreitet, in dem zweiten Modus aufweist,
- die Analyseschaltung (114, 720, 816) konfiguriert ist, um das Leistungssignal (112, 716, 814), das einen von der Audio- und/oder Videoverarbeitungsschaltung (106) im normalen Betrieb erforderlichen Eingangsspannungspegel anzeigt, zu erzeugen und
- die Spannungswandlersteuerschaltung (110, 216, 314, 410, 502, 718, 812) konfiguriert ist, um den Leistungswandler (102, 212, 312, 712, 802) anzusteuern, um:
i) im ersten Modus zu arbeiten, wenn der angezeigte Eingangsspannungspegel unterhalb des ersten Ausgangsspannungspegels liegt, oder
ii) im zweiten Modus zu arbeiten, wenn der angezeigte Eingangsspannungspegel über dem ersten Ausgangsspannungspegel liegt.

5. Vorrichtung (700) nach Anspruch 4, wobei
- der Leistungswandler (102, 212, 312, 712, 802) eine Primärseite zum Empfangen der Netzspannung (108), eine Sekundärseite zum Liefern der Ausgangsspannung (211, 804) und eine Rückkopplungsschaltung (213) zum Liefern einer Rückkopplung an die Primärseite aufweist, wobei die Rückkopplung mit dem Ausgangsspannungspegel zusammenhängt, um auf der Primärseite eine Energieübertragung auf die Sekundärseite zum Stabilisieren der Ausgangsspannung (211, 804) auf einem speziellen Pegel zu steuern, und
- die Spannungswandlersteuerung (110, 216, 314, 410, 502, 718, 812) konfiguriert ist, um den Betrieb der Rückkopplungsschaltung (213) zum Steuern des Leistungswandlers (102, 212, 312, 712, 802) zum Arbeiten in dem ersten Modus oder in dem zweiten Modus zu ändern.

6. Vorrichtung (700) nach Anspruch 1, wobei
- der Leistungswandler (102, 212, 312, 712, 802) eine Reihenanordnung aus einer Leistungsfaktorkorrekturschaltung (402, 606) und einem Netzleistungswandler (406, 604) zum Liefern von Energie an die Audio- und/oder Videoverarbeitungsschaltung (106) aufweist,
- die Leistungsfaktorkorrekturschaltung (402, 606) konfiguriert ist, um den Netzleistungswandler (406, 604) als Antwort auf das Leistungssignal (112, 716, 814) in dem ersten Modus mit einer ersten Spannung und in dem zweiten Modus mit einer zweiten Spannung, die die erste Spannung überschreitet, zu versorgen.

7. Vorrichtung (770) nach Anspruch 1, wobei der Leistungswandler (102, 212, 312, 712, 802) konfiguriert ist, um eine mittlere Leistung in dem ersten Modus und eine Spitzenleistung, die größer als die mittlere Leistung ist, in dem zweiten Modus zu liefern.

8. Vorrichtung (700) nach Anspruch 7, wobei
- der Leistungswandler (102, 212, 312, 712, 802) eine Reihenanordnung aus einer Leistungsfaktorkorrekturschaltung (402, 606) und einem Netzleistungswandler (406, 604) zum Liefern von Energie an die Audio- und/oder Videoverarbeitungsschaltung (106) aufweist,
- die Leistungsfaktorkorrekturschaltung (402, 606) eine Durchschnittsleistungsfaktorkorrekturschaltung (302) zum Übertragen der durchschnittlichen Leistung in sowohl dem ersten als auch dem zweiten Modus aufweist,
- die Leistungsfaktorkorrekturschaltung (402, 606) eine Spitzenleistungsfaktorkorrekturschaltung (304) zum Übertragen einer über der durchschnittlichen Leistung erforderlichen übermäßigen Leistung in dem zweiten Modus aufweist, und
- die Leistungswandlersteuerung (110, 216, 314, 410, 502, 718, 812) die Spitzenleistungsfaktorkorrekturschaltung (304) in dem zweiten Modus aktiviert und die Spitzenleistungsfaktorkorrekturschaltung (304) in dem ersten Modus deaktiviert.

9. Vorrichtung (700) nach Anspruch 7, wobei
- der Leistungswandler (102, 212, 312, 712, 802) eine Reihenanordnung aus einer Leistungsfaktorkorrekturschaltung (402, 606) und einem Netzleistungswandler (406, 604) zum Liefern von Energie an die Audio- und/oder Videoverarbeitungsschaltung (106) aufweist,
- der Netzleistungswandler (406, 604) einen Durchschnittsnetzleistungswandler (308) zum Übertragen der durchschnittlichen Leistung sowohl in dem ersten Modus als auch in dem zweiten Modus aufweist,
- der Hauptleistungswandler (406, 604) einen Spitzennetzleistungswandler (308) zum Übertragen einer über der durchschnittlichen Leistung erforderlichen übermäßigen Leistung in dem zweiten Modus aufweist, und
- die Leistungswandlersteuerung (110, 216, 314, 410, 502, 718, 812) den Spitzennetzleistungswandler (308) in dem zweiten Modus aktiviert und den Spitzennetzleistungswandler (308) in dem ersten Modus deaktiviert.

10. Vorrichtung (700) nach Anspruch 1, wobei
- der Leistungswandler (102, 212, 312, 712, 802) eine Reihenanordnung aus einer Leistungsfaktorkorrekturschaltung (402, 406) und einem Netzleistungswandler (406, 604) zum Liefern von Energie an die Audio- und/oder Videoverarbeitungsschaltung (106) aufweist,
- der Hauptleistungswandler (406, 604) aufweist
i) eine Induktivität (L1) und einen Stromsensor (R1),
ii) einen Schalter (T1) zum Erzeugen eines periodisch variierenden Stroms durch die Induktivität (L1),
iii) eine Rückkopplungsschaltung zum Liefern eines Rückkopplungssignals, das mit dem Strom durch die Induktivität (L1), der durch eine Spannung über den Stromsensor (R1) gemessen wird, zusammenhängt, und
iv) eine Schaltersteuerung (602) zum Steuern des Schalters (T1) als Antwort auf das Rückkopplungssignal,
- wobei die Leistungswandlersteuerung (110, 216, 314, 410, 502, 718, 812) konfiguriert ist, um den Betrieb der Rückkopplungsschaltung zu ändern und den Leistungswandler (102, 212, 312, 712, 802) zu steuern, um in dem ersten Modus oder in dem zweiten Modus zu arbeiten.

11. Vorrichtung (700) nach Anspruch 1, umfassend ein Signalverarbeitungssystem (900), das umfasst
- eine Leistungsanalyseschaltung (902) zum Analysieren der Leistung (104), die von dem Leistungswandler (102, 212, 312, 712, 802) bereitgestellt wird, und zum Erzeugen eines weiteren Leistungssignals (904), das mit der bereitgestellten Leistung (104) zusammenhängt,
- eine Audio- und/oder Videoverarbeitungsschaltung (906) zum Verarbeiten des Signals (116, 818), wobei die Audio- und/oder Videoverarbeitungsschaltung (906) konfiguriert ist, um
i) zumindestens eines aus der Gruppe des Leistungssignals (112, 716, 814) und dem weiteren Leistungssignal (904) zu empfangen, und
iia) das Signal (116, 818) in Abhängigkeit von dem weiteren Leistungssignal (904) zu verarbeiten, oder
iib) Abweichungen zwischen dem Leistungssignal (112, 716, 814) und dem weiteren Leistungssignal (904) zu detektieren und das Signal (116, 818) in Abhängigkeit von dem Leistungssignal (112, 716, 814) und den detektierten Abweichungen zu verarbeiten.

12. Vorrichtung (700) nach einem der vorangehenden Ansprüche, wobei die Vorrichtung eine Anzeigevorrichtung ist und das Audio- und/oder Videosignal ein Videosignal (714) ist.

13. Vorrichtung nach Anspruch 12, wobei die Vorrichtung (700) eine LCD-Anzeigeeinrichtung (702) zum Präsentieren von Videoinformation aufweist, wobei die Audio- und/oder Videoverarbeitungsschaltung eine Hintergrundbeleuchtungseinheit (700) und eine Hintergrundbeleuchtungssteuerung (707) zum Steuern einer Intensität von Licht, das von der Hintergrundbeleuchtungseinheit (704) emittiert wird, als Antwort auf das Steuersignal aufweist.

14. Vorrichtung nach einem der Ansprüche 1 bis 11, wobei die Vorrichtung ein Audiosystem (800, 1000) aufweist, wobei das Audio- und/oder Videosignal ein Audiosignal (108) ist und wobei die Audio- und/oder Videoverarbeitungsschaltung einen Verstärker (806) zum Verstärken eines Audiosignals (818) aufweist.

15. Verfahren (1100) zum Betreiben einer Vorrichtung mit einem Leistungswandler zum Empfangen einer Netzspannung und zum Liefern von Energie an eine Audio- und/oder Videoverarbeitungsschaltung zum Verarbeiten eines Audio- und/oder Videosignals und einer Leistungswandlersteuerung, **dadurch gekennzeichnet, dass** das Verfahren die Schritte umfasst:
- Analysieren (1102) des Signals,
- Erzeugen (1104) ein Leistungssignal, das einen Energieverbrauch der Audio- und/oder Videoverarbeitungsschaltung anzeigt, wenn sich die Audio- und/oder Videoverarbeitungsschaltung in einem Normalbetrieb befindet, und
- Liefern (1106) des Leistungssignals an die Leistungswandlersteuerung, und
- Steuern (1108) des Leistungswandlers, um
i) in einem ersten Modus zu arbeiten, wenn das Leistungssignal anzeigt, dass der Energieverbrauch der Audio- und/oder Videoverarbeitungsschaltung unterhalb eines ersten Leistungspegels liegt, oder
ii) in einem zweiten Modus zu arbeiten, wenn das Leistungssignal anzeigt, dass der Energieverbrauch der Audio- und/oder Videoverarbeitungsschaltung über dem ersten Leistungspegel liegt,
wobei der Leistungswandler fähig ist, in dem ersten Modus den ersten Leistungspegel bereitzustellen, und in dem zweiten Modus den zweiten Leistungspegel bereitzustellen, der den ersten Leistungspegel überschreitet.

## Revendications

1. Appareil (700) comprenant:
- un circuit de traitement audio et/ou vidéo (106), et
- un convertisseur de puissance (102, 212, 312, 712, 802) destiné à recevoir une tension de secteur (108) et à fournir de la puissance (104, 708) au circuit de traitement audio et/ou vidéo (106), **caractérisé en ce que** le convertisseur de puissance (102, 212, 312, 712, 802) est configuré pour fonctionner dans au moins deux modes, un premier mode dans lequel le convertisseur de puissance (102, 212, 312, 712, 802) est capable de fournir un premier niveau de puissance, et un deuxième mode dans lequel le convertisseur de puissance est capable de fournir un deuxième niveau de puissance qui dépasse le premier niveau de puissance, et **en ce que** l'appareil comprend :
- un circuit d'analyse (114, 720, 816) destiné à analyser un signal audio et/ou vidéo (116, 818) traité par le circuit de traitement audio et/ou vidéo (106) pour générer un signal de puissance (112, 716, 814) indiquant une consommation de puissance du circuit de traitement audio et/ou vidéo (106) en fonctionnement normal, et
- une unité de commande (110, 216, 314, 410, 502, 718, 812) de convertisseur de puissance destiné à recevoir le signal de puissance (112, 716, 814) et à commander le convertisseur de puissance (102, 212, 312, 712, 802) :
i) pour fonctionner dans le premier mode lorsque le signal de puissance (112, 716, 814) indique que la consommation de puissance du circuit de traitement audio et/ou vidéo (106) est inférieure au premier niveau de puissance, ou
ii) pour fonctionner dans le deuxième mode lorsque le signal de puissance (112, 716, 814) indique que la consommation de puissance du circuit de traitement audio et/ou vidéo (106) est supérieure au premier niveau de puissance.

2. Appareil (700) selon la revendication 1, dans lequel le signal de puissance (112, 716, 814) indique que la consommation de puissance du circuit de traitement audio et/ou vidéo (106) est prévue pour être consommée pendant un intervalle de temps qui suit un instant auquel le signal de puissance est reçu.

3. Appareil (700) selon la revendication 1, dans lequel
- le convertisseur de puissance (102, 212, 312, 712, 802) est configuré pour fonctionner dans l'un d'une pluralité de modes, comportant le premier mode et le deuxième mode, où, dans chacun de la pluralité de modes, le convertisseur de puissance (102, 212, 312, 712, 802) est capable de fournir un niveau de puissance spécifique d'une pluralité de niveaux de puissance, et
- l'unité de commande (110, 216, 314, 410, 502, 718, 812) de convertisseur de puissance est configurée pour commander le convertisseur de puissance (102, 212, 312, 712, 802) afin de fonctionner dans l'un de la pluralité de modes qui correspond le mieux à la consommation de puissance indiquée par le signal de puissance (112, 716, 814).

4. Appareil (700) selon la revendication 1, dans lequel
- le convertisseur de puissance (102, 212, 312, 712, 802) est configuré pour fournir une tension de sortie (211, 804) au circuit de traitement audio et/ou vidéo (106), la tension de sortie ayant un premier niveau de tension de sortie dans le premier mode et un deuxième niveau de tension de sortie dépassant le premier niveau de tension de sortie dans le deuxième mode,
- le circuit d'analyse (114, 720, 816) est configuré pour générer le signal de puissance (112, 716, 814) indiquant un niveau de tension d'entrée requis par le circuit de traitement audio et/ou vidéo (106) en fonctionnement normal, et
- le circuit d'unité de commande (110, 216, 314, 410, 502, 718, 812) de convertisseur de puissance est configuré pour commander le convertisseur de puissance (102, 212, 312, 712, 802) :
i) pour fonctionner dans le premier mode lorsque le niveau de tension d'entrée indiqué est inférieur au premier niveau de tension de sortie, ou
ii) pour fonctionner dans le deuxième mode lorsque le niveau de tension d'entrée indiqué est supérieur au premier niveau de tension de sortie.

5. Appareil (700) selon la revendication 4, dans lequel
- le convertisseur de puissance (102, 212, 312, 712, 802) comprend un côté primaire pour recevoir la tension de secteur (108), un côté secondaire pour fournir la tension de sortie (211, 804), et un circuit de rétroaction (213) pour fournir une rétroaction au côté primaire, cette rétroaction est liée au niveau de tension de sortie, afin de commander au niveau du côté primaire un transfert de puissance au côté secondaire pour la stabilisation de la tension de sortie (211, 804) à un niveau spécifique, et
- l'unité de commande (110, 216, 314, 410, 502, 718, 812) de convertisseur de puissance est configurée pour modifier le fonctionnement du circuit de rétroaction (213) afin de commander le convertisseur de puissance (102, 212, 312, 712, 802) pour fonctionner dans le premier mode ou dans le deuxième mode.

6. Appareil (700) selon la revendication 1, dans lequel
- le convertisseur de puissance (102, 212, 312, 712, 802) comprend un agencement en série d'un circuit de correction de facteur de puissance (402, 606) et d'un convertisseur de puissance principale (406, 604) pour fournir de la puissance au circuit de traitement audio et/ou vidéo (106),
- le circuit de correction de facteur de puissance (402, 606) est configuré pour fournir au convertisseur de puissance principale (406, 604), en réponse au signal de puissance (112, 716, 814), dans le premier mode une première tension, et dans le deuxième mode une deuxième tension dépassant la première tension.

7. Appareil (700) selon la revendication 1, dans lequel le convertisseur de puissance (102, 212, 312, 712, 802) est configuré pour fournir une puissance moyenne dans le premier mode et une puissance de crête qui est supérieure à la puissance moyenne dans le deuxième mode.

8. Appareil (700) selon la revendication 7, dans lequel
- le convertisseur de puissance (102, 212, 312, 712, 802) comprend un agencement en série d'un circuit de correction de facteur de puissance (402, 606) et d'un convertisseur de puissance principale (406, 604) pour fournir de la puissance au circuit de traitement audio et/ou vidéo (106),
- le circuit de correction de facteur de puissance (402, 606) comprend un circuit de correction de facteur de puissance moyenne (302) pour transférer la puissance moyenne à la fois dans les premier et deuxième modes,
- le circuit de correction de facteur de puissance (402, 606) comprend un circuit de correction de facteur de puissance de crête (304) pour transférer une puissance excessive requise supérieure à la puissance moyenne dans le deuxième mode, et
- l'unité de commande (110, 216, 314, 410, 502, 718, 812) de convertisseur de puissance active le circuit de correction de facteur de puissance de crête (304) dans le deuxième mode et inactive le circuit de correction de facteur de puissance de crête (304) dans le premier mode.

9. Appareil (700) selon la revendication 7, dans lequel
- le convertisseur de puissance (102, 212, 312, 712, 802) comprend un agencement en série d'un circuit de correction de facteur de puissance (402, 606) et d'un convertisseur de puissance principale (406, 604) pour fournir de la puissance au circuit de traitement audio et/ou vidéo (106),
- le convertisseur de puissance principale (406, 604) comprend un convertisseur de puissance moyenne principale (308) pour transférer la puissance moyenne à la fois dans le premier mode et le deuxième mode,
- le convertisseur de puissance principale (406, 604) comprend un convertisseur de puissance de crête principale (308) pour transférer une puissance excessive requise supérieure à la puissance moyenne dans le deuxième mode, et
- l'unité de commande (110, 216, 314, 410, 502, 718, 812) de convertisseur de puissance active le convertisseur de puissance de crête principale (308) dans le deuxième mode et inactive le convertisseur de puissance de crête principale (308) dans le premier mode.

10. Appareil (700) selon la revendication 1, dans lequel
- le convertisseur de puissance (102, 212, 312, 712, 802) comprend un agencement en série d'un circuit de correction de facteur de puissance (402, 606) et d'un convertisseur de puissance principale (406, 604) pour fournir de la puissance au circuit de traitement audio et/ou vidéo (106),
- le convertisseur de puissance principale (406, 604) comprend
i) une inductance (L1) et un capteur de courant (R1),
ii) un interrupteur (T1) pour générer un courant variant périodiquement à travers l'inductance (L1),
iii) un circuit de rétroaction pour fournir un signal de rétroaction lié au courant à travers l'inductance (L1) qui est détecté par une tension à travers le capteur de courant (R1), et
iv) une unité de commande (602) d'interrupteur pour commander l'interrupteur (T1) en réponse au signal de rétroaction,
- l'unité de commande (110, 216, 314, 410, 502, 718, 812) de convertisseur de puissance est configurée pour modifier le fonctionnement du circuit de rétroaction afin de commander le convertisseur de puissance (102, 212, 312, 712, 802) pour fonctionner dans le premier mode ou dans le deuxième mode.

11. Appareil (700) selon la revendication 1, comprenant un système de traitement de signal (900) qui comprend :
- un circuit d'analyse de puissance (902) destiné à analyser la puissance (104) qui est fournie par le convertisseur de puissance (102, 212, 312, 712, 802) et à générer un signal de puissance supplémentaire (904) qui est lié à la puissance fournie (104),
- un circuit de traitement audio et/ou vidéo (906) destiné à traiter le signal (116, 818), le circuit de traitement audio et/ou vidéo (906) étant configuré :
i) pour recevoir au moins un signal du groupe du signal de puissance (112, 716, 814) et du signal de puissance supplémentaire (904), et
iia) pour traiter le signal (116, 818) en fonction du signal de puissance supplémentaire (904), ou
iib) pour détecter des écarts entre le signal de puissance (112, 716, 814) et le signal de puissance supplémentaire (904), et pour traiter le signal (116, 818) en fonction du signal de puissance (112, 716, 814) et des écarts détectés.

12. Appareil (700) selon l'une des revendications précédentes, où l'appareil est un appareil d'affichage et le signal audio et/ou vidéo est un signal vidéo (714).

13. Appareil selon la revendication 12, où l'appareil (700) comprend un dispositif d'affichage LCD (702) pour présenter des informations vidéo, le circuit de traitement audio et/ou vidéo comprenant une unité de rétroéclairage (704) et une unité de commande de rétroéclairage (707) pour commander une intensité de la lumière émise par l'unité de rétroéclairage (704) en réponse au signal de puissance.

14. Appareil selon l'une des revendications 1 à 11, où l'appareil comprend un système audio (800, 1000), dans lequel le signal audio et/ou vidéo est un signal audio (108), et dans lequel le circuit de traitement audio et/ou vidéo comprend un amplificateur (806) pour amplifier un signal audio (818).

15. Procédé (1100) de fonctionnement d'un appareil comprenant un convertisseur de puissance destiné à recevoir une tension de secteur et à fournir de la puissance à un circuit de traitement audio et/ou vidéo pour traiter un signal audio et/ou vidéo, et une unité de commande de convertisseur de puissance, **caractérisé en ce que** le procédé comprend les étapes qui consistent .
- à analyser (1102) le signal,
- à générer (1104) un signal de puissance indiquant une consommation de puissance du circuit de traitement audio et/ou vidéo lorsque le circuit de traitement audio et/ou vidéo est en fonctionnement normal, et
- à fournir (1106) le signal de puissance à l'unité de commande de convertisseur de puissance, et
- à commander (1108) le convertisseur de puissance pour fonctionner
i) dans un premier mode lorsque le signal de puissance indique que la consommation de puissance du circuit de traitement audio et/ou vidéo est inférieure à un premier niveau de puissance, ou
ii) dans un deuxième mode lorsque le signal de puissance indique que la consommation de puissance du circuit de traitement audio et/ou vidéo est supérieure au premier niveau de puissance,
dans lequel le convertisseur de puissance est capable de fournir dans le premier mode, le premier niveau de puissance et dans le deuxième mode, le deuxième niveau de puissance dépassant le premier niveau de puissance.
